# EUROPEAN PATENT APPLICATION

(11) **EP 4 845 335 A1**
(43) Date of publication of application: **25.11.2026**
(21) Application number: 26160516.6
(22) Date of filing: 24.02.2026
(51) Int. Cl.: H10D 30/01, H10D 30/66, H10D 62/10, H10D 62/13, H10D 62/832, H10D 64/01, H10D 64/27

(54) **SEMICONDUCTOR DEVICE HAVING RESISTOR**

(30) Priority: 23.05.2025 KR 20250067557
(71) Applicant: Samsung Electronics Co., Ltd., Suwon-si, Gyeonggi-do 16677 (KR)
(72) Inventor: KO, Mingu, Suwon-si (KR); PARK, Gyeong-Seon, Suwon-si (KR); YUN, Jihoon, Suwon-si (KR); HONG, JeongPyo, Suwon-si (KR)
(74) Representative: Marks & Clerk LLP

(57) **Abstract**

A semiconductor device includes a substrate (110) having a cell region (101) and a peripheral region (102) positioned on a first side of the cell region, a semiconductor layer of a first conductivity type (131) positioned on the peripheral region of the substrate, a first well region of a second conductivity type (233) positioned on the semiconductor layer of the first conductivity type, a contact well region of the first conductivity type (237) positioned on the first well region of the second conductivity type, and a gate pad (155) positioned on the first well region of the second conductivity type, wherein the gate pad includes a first gate pad member (155_1) connected to a first side of the contact well region of the first conductivity type and a second gate pad member (155_2) spaced apart from the first gate pad member and connected to a second side of the contact well region of the first conductivity type.

## Description

### BACKGROUND OF THE INVENTION

The present disclosure relates to a semiconductor device.

In modern society, semiconductor devices are closely related to daily life. In particular, the importance of power semiconductor devices used in various fields such as transportation fields including electric vehicles, railroads, and electric trams, renewable energy systems such as solar power generation and wind power generation, and mobile devices is gradually increasing. A power semiconductor device is a semiconductor device used to handle high voltage or high current, and performs functions such as power conversion and control in large-scale power systems or high-output electronic devices. A power semiconductor device has the capability and durability to process high power, and may handle a large amount of current and withstand high voltage. For example, a power semiconductor device may process a voltage from several hundreds of volts to several thousands of volts and a current from several tens of amperes to several thousands of amperes. The power semiconductor device may enhance the efficiency of electrical energy by minimizing power loss. In addition, the power semiconductor device may be operated stably even in environments such as high temperatures.

Such power semiconductor devices may be classified according to the material, and for example, there are SiC power semiconductor devices and GaN power semiconductor devices. By manufacturing a power semiconductor device using SiC or GaN instead of a conventional silicon wafer (Si wafer), it may be possible to compensate for the disadvantages of silicon having unstable characteristics at high temperatures. The SiC power semiconductor device is resistant to high temperatures, has low power loss, and may be suitable for electric vehicles, renewable energy systems, and the like. The GaN power semiconductor device may require high cost but is efficient in terms of speed, and may be suitable for high-speed charging of a mobile device or the like.

### SUMMARY OF THE INVENTION

One aspect of the present disclosure provides a semiconductor device that may prevent ringing, which is a phenomenon in which the gate voltage oscillates at a high frequency due to parasitic inductance during high-speed switching operation, may reduce electromagnetic interference, and may prevent excessive current from flowing through the device.

An embodiment of the present disclosure provides a semiconductor device including a substrate having a cell region and a peripheral region positioned at a first side of the cell region, a semiconductor layer of a first conductivity type positioned on the peripheral region of the substrate, a first well region of a second conductivity type positioned in the semiconductor layer of the first conductivity type, a contact well region of the first conductivity type positioned in the first well region of the second conductivity type, and a gate pad positioned on the first well region of the second conductivity type, wherein the gate pad includes a first gate pad member connected to a first side of the contact well region of the first conductivity type and a second gate pad member spaced apart from the first gate pad member and connected to a second side of the contact well region of the first conductivity type.

Another embodiment of the present disclosure provides a semiconductor device including a substrate having a cell region and a peripheral region positioned on a side of the cell region, a semiconductor layer of a first conductivity type positioned on the peripheral region of the substrate, a first well region of a second conductivity type positioned in the semiconductor layer of the first conductivity type, a contact well region of the first conductivity type positioned in the first well region of the second conductivity type, a gate pad positioned on the first well region of the second conductivity type and connected to the contact well region of the first conductivity type, and a source pad connected to the first well region of the second conductivity type and spaced apart from the gate pad, wherein the gate pad and the source pad are connected to each other by the first well region of the second conductivity type.

Another embodiment of the present disclosure provides a semiconductor device including a substrate having a cell region and a peripheral region positioned on a side of the cell region, a semiconductor layer of a first conductivity type positioned on the peripheral region of the substrate, a first well region of a second conductivity type positioned in the semiconductor layer of the first conductivity type, a contact well region of the first conductivity type positioned in the first well region of the second conductivity type, a gate pad positioned on the first well region of the second conductivity type, connected to the contact well region of the first conductivity type, and having an electrical resistance determined by the contact well region of the first conductivity type, and a source pad connected to the first well region of the second conductivity type and spaced apart from the gate pad.

The semiconductor device according to the examples may prevent the occurrence of ringing, which is a phenomenon in which the gate voltage oscillates at a high frequency due to parasitic inductance during high-speed switching operation, may reduce electromagnetic interference, and may prevent excessive current from flowing through the device.

In at least some examples, by including a rectification structure, when an unintended negative voltage is applied to the gate pad, accumulated negative charges may be extracted to the source pad, thereby preventing the threshold voltage (Vₜₕ) of the device from being changed by the accumulated negative charges.

At least some of the above and other features of the invention are set out in the claims.

### BRIEF DESCRIPTION OF THE DRAWINGS

FIG. 1 is a plan view showing a semiconductor device according to an example.
FIG. 2 is a cross-sectional view taken along the line A-A' of FIG. 1.
FIG. 3 is a cross-sectional view taken along the line B-B' of FIG. 1.
FIG. 4 is a cross-sectional view showing a semiconductor device according to an example, and corresponds to FIG. 2.
FIG. 5 is a cross-sectional view showing a semiconductor device according to an example, and corresponds to FIG. 2.
FIG. 6 is a cross-sectional view showing a semiconductor device according to an example, and corresponds to FIG. 2.
FIG. 7 is a cross-sectional view showing a semiconductor device according to an example, corresponding to FIG. 2.
FIG. 8 is a cross-sectional view showing a semiconductor device according to an example, and corresponds to FIG. 2.
FIGS. 9 to 17 are cross-sectional views showing a method of manufacturing a semiconductor device according to a process sequence.

### DETAILED DESCRIPTION OF THE EMBODIMENTS

Hereinafter, various embodiments of the present disclosure will be described in detail with reference to the attached drawings so that a person having ordinary skill in the art to which the present disclosure pertains can easily implement the present disclosure. The inventive concept may, however, be embodied in many different forms and is not limited to the embodiments set forth herein. It should also be emphasized that the disclosure provides details of alternative examples, but such listing of alternatives is not exhaustive. Furthermore, any consistency of detail between various examples should not be interpreted as requiring such detail. The language of the claims should be referenced in determining the requirements of the invention.

The drawings and description are to be regarded as illustrative in nature and not restrictive. Like reference numerals designate like elements throughout the specification.

The size and thickness of each constituent element as shown in the drawings are randomly indicated for better understanding and ease of description, and this disclosure is not necessarily limited to as shown. In the drawings, the thickness of layers, regions, etc., are exaggerated for clarity. In addition, in the drawings, for better understanding and ease of description, the thickness of some layers and areas is exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means being disposed on or below the object portion, and does not necessarily mean being disposed on the upper side of the object portion based on a gravitational direction.

It will be understood that when an element is referred to as being "connected" or "coupled" another element, it can be directly connected or coupled to the other element or intervening elements may be present. In contrast, when an element is referred to as being "directly connected" or "directly coupled" to another element, or as "contacting" or "in contact with" another element (or using any form of the word "contact"), there are no intervening elements present at the point of contact. As used herein, items described as being "electrically connected" are configured such that an electrical signal can be passed from one item to the other.

The various pads described herein may generally have a planar upper surface having horizontal dimensions (e.g., in both the X and Y directions) that are both larger than wiring to which the pad is connected to facilitate connections thereto (e.g., to provide a larger surface to contact a later formed via). For example, a horizontal wiring may be integrally formed with a pad (e.g., patterned out of the same metal layer) such that the wiring and pad have coplanar upper surfaces, with both of the X and Y horizontal dimensions of the pad being greater than the horizontal width of the wiring (e.g., greater or equal to 3 times the horizontal width of the wiring). In other examples, a pad may be discretely formed such that it is not in contact with any wiring formed at its vertical level within the device and is only connected to wiring within the device by vias. From a top down view, a pad may have a symmetrical shape (e.g., a square or rectangular footprint) and may have X and Y horizontal dimensions that are about the same (e.g., within half to two times of the other).

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be referenced elsewhere without an ordinal number or with a different ordinal number (e.g., "second" in the specification or another claim).

In addition, unless explicitly described to the contrary, the word "comprise," and variations such as "comprises" or "comprising," will be understood to imply the inclusion of stated elements but not the exclusion of any other elements.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

Terms such as "same," "equal," "planar," "coplanar," "parallel," and "perpendicular," as used herein encompass identicality or near identicality including variations that may occur resulting from conventional manufacturing processes. The term "substantially" may be used herein to emphasize this meaning, unless the context or other statements indicate otherwise.

In addition, in this specification, the phrase "in a plan view" means viewing a target portion from the top, and the phrase "in a cross-sectional view" means viewing a cross-section formed by vertically cutting a target portion from the side.

In addition, throughout the specification, two directions parallel to the upper surface of the substrate and perpendicular to each other are respectively defined as a first direction D1 and a second direction D2, and a direction perpendicular to the upper surface of the substrate is described as a third direction D3. For example, the first direction D1 and the second direction D2 may be the length direction and the width direction, respectively, and the third direction D3 may be the thickness direction.

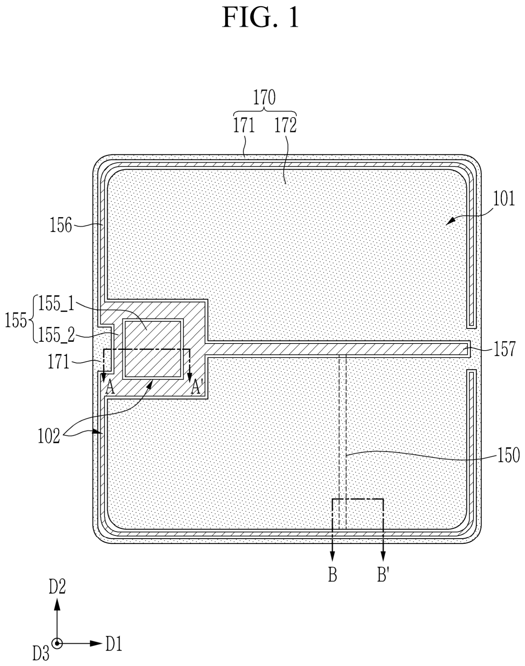

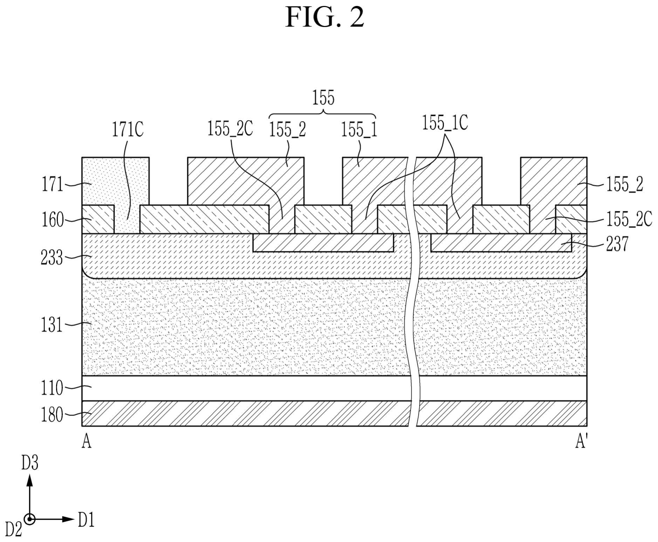

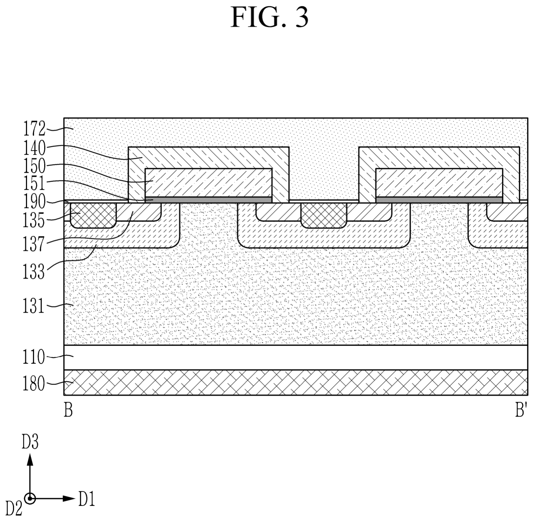

FIG. 1 is a plan view showing a semiconductor device according to an example. FIG. 2 is a cross-sectional view taken along the line A-A' of FIG. 1. FIG. 3 is a cross-sectional view taken along line B-B' of FIG. 1.

For a clear understanding and simplified illustration, features that are unnecessary in the description of the embodiments may be omitted in the following description. FIG. 1 shows a source pad member 171 and a source pad 170, a source electrode 172, a first gate pad member 155_1 and a second gate pad member 155_2 of a gate pad 155, a gate runner 156, and a gate bus 157. The first gate pad member 155_1 may be a first portion of the gate pad 155 and the second gate pad member 155_2 may be a second portion of the gate pad 155.

Referring to FIG. 1 and FIG. 2, a semiconductor device includes a substrate 110 having a cell region 101 and a peripheral region 102, a first conductivity type semiconductor layer 131 (e.g., a semiconductor layer comprised of a semiconductor material having a first conductivity type) positioned on the peripheral region 102 of the substrate 110, a first well region of a second conductivity type 233 positioned in the first conductivity type semiconductor layer 131, a contact well region of the first conductivity type 237 positioned in the first well region of the second conductivity type 233, and a gate pad 155 positioned on the first well region of the second conductivity type 233.

The substrate 110 may have a cell region 101 and a peripheral region 102 positioned at a side of the cell region 101. For example, the peripheral region 102 may surround the cell region 101.

On the cell region 101 of the substrate 110, the source electrode 172 of the source pad 170 may be positioned.

For example, the source pad 170 may include a source pad member 171 and the source electrode 172, the source electrode 172 of the source pad 170 may be positioned on the cell region 101 of the substrate 110, and the source pad member 171 of the source pad 170 may be positioned on the peripheral region 102 of the substrate 110.

The source electrode 172 may cover the cell region 101 of the substrate 110 entirely. For example, the cell region 101 of the substrate 110 may be entirely overlapped with the source electrode 172 in the third direction D3.

The gate pad 155 may be positioned on the peripheral region 102 of the substrate 110. The gate pad 155 may be positioned on a first side in the first direction D1 or the second direction D2 of the source electrode 172. The gate pad 155 may be spaced apart from the source electrode 172 in the first direction D1 or the second direction D2. The gate pad 155 and the source electrode 172 may not be directly connected (e.g., may not be in contact with one another).

For example, in a plan view extending in the first direction D1 and the second direction D2 perpendicular to the third direction D3 (hereinafter referred to as "in a plan view", for example, in FIG. 1), the size (e.g., a first footprint) of the gate pad 155 may be smaller than the size (e.g., a second footprint) of the source electrode 172. The gate pad 155 may be positioned close to a first side edge of the source electrode 172. The gate pad 155 may be positioned at approximately the middle of the first side of the source electrode 172. Other sides of the gate pad 155, except for a first side of the gate pad 155, may be surrounded by the source electrode 172. The source electrode 172 may have an overall rectangular shape, and the source electrode 172 may have a concave portion that is curved inward on the first side of the source electrode 172, and the gate pad 155 may be positioned within the concave portion of the source electrode 172. At least a portion of the gate pad 155 may be inserted into the source electrode 172 and may be positioned within the source electrode 172.

For example, the source electrode 172 may have a first portion positioned on a side of the gate pad 155 in the first direction D1 and having a larger area than the gate pad 155, a second portion positioned on a second side of the gate pad 155 in the second direction D2 and on a side of the first portion in the first direction D1, wherein the second portion has a length in the first direction D1 similar to that of the gate pad 155 and a length in the second direction D2 smaller than that of the first portion, and a third portion positioned on a third side of the gate pad 155 in the second direction D2 and on the side of the first portion in the first direction D1, wherein the third portion has a length in the first direction D1 similar to that of the gate pad 155 and a length in the second direction D2 smaller than that of the first portion.

In some examples, the gate runner 156 may be positioned on the peripheral region 102 of the substrate 110. The gate runner 156 may be connected to the gate pad 155. The gate runner 156 may extend along the periphery of the source electrode 172 from the gate pad 155. The gate runner 156 may extend to be positioned over the entire peripheral region 102. For example, the gate runner 156 may surround the source electrode 172. The gate runner 156 may be spaced apart from the source electrode 172 in the first direction D1 and/or the second direction D2. The gate runner 156 and the source electrode 172 may not be directly connected to each other (e.g., may not contact one another).

The gate bus 157 may be positioned on the peripheral region 102 of the substrate 110. The gate bus 157 may be connected to the gate pad 155. The gate bus 157 may extend across the source electrode 172 from the gate pad 155. The gate bus 157 may extend across the source electrode 172 so as to bisect a portion of the source electrode 172 in a plan view. However, the gate bus 157 does not completely divide the source electrode 172, and the source electrode 172 may be connected at a first end of the gate bus 157. For example, the gate bus 157 may not be directly connected to the gate runner 156, and may be connected through the gate pad 155. The gate bus 157 may be spaced apart from the source electrode 172 in the second direction D2. The gate bus 157 and the source electrode 172 may not be directly connected to each other.

In some examples, the source pad member 171 of the source pad 170 may be positioned on the peripheral region 102 of the substrate 110.

The source pad member 171 may extend along a periphery of the gate runner 156. The source pad member 171 may extend to be positioned over the entire peripheral region 102. For example, the source pad member 171 may surround the gate runner 156, and the source pad member 171 may surround the source electrode 172 that is surrounded by the gate runner 156.

The source pad member 171 may be spaced apart from the gate runner 156 in the first direction D1 or in the second direction D2. The source pad member 171 and the gate runner 156 may not be directly connected to each other.

The source pad member 171 may be connected to the source electrode 172. For example, the gate runner 156 may extend so as to be positioned over the entire peripheral region 102, but instead of a completely closed frame shape, may have a gap in which a first end and a second end are not connected to each other and are open (e.g., form an open gap). The source pad member 171 may be positioned in the open gap of the gate runner 156, and the source pad member 171 and the source electrode 172 may be connected to each other through the open gap of the gate runner 156.

As such, the cell region 101 of the substrate 110 may be defined as a region in which the source electrode 172 is positioned, and the peripheral region 102 of the substrate 110 may be defined as a region in which the gate pad 155, the gate runner 156, the gate bus 157, and the source pad member 171 are positioned.

The substrate 110 may be a semiconductor substrate including SiC. For example, the substrate 110 may be a 4H SiC substrate. In some cases, the substrate 110 may be a 3C SiC substrate, or a 6H SiC substrate, and the like. The substrate 110 may be doped with a first conductivity type impurity. For example, the first conductivity type impurity may be an n-type impurity. For example, the substrate 110 may be doped as an n-type. The substrate 110 may be highly doped with an n-type. The resistivity of the substrate 110 may be in the range of 0.005 Ω·cm and 0.035 Ω·cm. The thickness of the substrate 110 may be in the range of 10 µm and 700 µm. The material, doping type, doping concentration, specific resistance, or thickness of the substrate 110 is not limited thereto, and may be variously changed. The substrate 110 may have a first surface and a second surface on opposite sides facing away from each other. The first surface of the substrate 110 may be the upper surface of the substrate 110, and the second surface of the substrate 110 may be the lower surface of the substrate 110.

The first conductivity type semiconductor layer 131 may be positioned on the first surface of the substrate 110 (e.g., the upper surface). The lower surface of the first conductivity type semiconductor layer 131 may be in contact with the upper surface of the substrate 110. However, this is not limited thereto, and another layer may be further positioned between the substrate 110 and the first conductivity type semiconductor layer 131. The first conductivity type semiconductor layer 131 may be an epitaxy layer formed using an epitaxial growth grown from the substrate 110 using an epitaxial growth method. The first conductivity type semiconductor layer 131 may include SiC. For example, the first conductivity type semiconductor layer 131 may include 4H SiC. The first conductivity type semiconductor layer 131 may be doped as an n-type. The first conductivity type semiconductor layer 131 may be low-concentration doped as an n-type. The doping concentration of the first conductivity type semiconductor layer 131 may be lower than the doping concentration of the substrate 110. The doping concentration of the first conductivity type semiconductor layer 131 may be in the range of 1×10¹⁵ cm⁻³ and 1×10¹⁷ cm⁻³. The thickness of the first conductivity type semiconductor layer 131 may be in the range of 1 µm and 13 µm. The material, doping type, or doping concentration of the first conductivity type semiconductor layer 131 is not limited thereto, and may be variously changed.

The first well region of the second conductivity type 233 may be positioned in the first conductivity type semiconductor layer 131. The first well region of the second conductivity type 233 may be positioned within the first conductivity type semiconductor layer 131. The first well region of the second conductivity type 233 may be positioned adjacent to an upper surface of the first conductivity type semiconductor layer 131. The upper surface of the first well region of the second conductivity type 233 and the upper surface of the first conductivity type semiconductor layer 131 may have the same level according to the third direction D3. For example, the upper surface of the first well region of the second conductivity type 233 and the upper surface of the first conductivity type semiconductor layer 131 may be coplanar surfaces (e.g., may form a single planar surface). The first conductivity type semiconductor layer 131 may surround the lower surface and side surfaces of the first well region of the second conductivity type 233.

In a plan view, the first well region of the second conductivity type 233 may extend in the first direction D1 and the second direction D2, and may have various planar shapes, and, for example, may have a polygonal shape such as a circular, elliptical, triangular, or rectangular shape. At least a portion of the first well region of the second conductivity type 233 may overlap with at least a portion of the gate pad 155 in the third direction D3. In some examples, at least a portion of the first well region of the second conductivity type 233 may overlap with at least a portion of the source pad member 171 of the source pad 170 in the third direction D3.

The first well region of the second conductivity type 233 may extend from the upper surface of the first conductivity type semiconductor layer 131 toward the lower surface of the first conductivity type semiconductor layer 131. For example, the first well region of the second conductivity type 233 may be extended from the upper surface of the first conductivity type semiconductor layer 131 to a certain depth in the third direction D3. The first well region of the second conductivity type 233 may be formed in at least a portion of the first conductivity type semiconductor layer 131 by an ion implantation method.

The first well region of the second conductivity type 233 may include SiC. For example, the first well region of the second conductivity type 233 may include 4H SiC. The first well region of the second conductivity type 233 may be doped to a p-type. The first well region of the second conductivity type 233 may be low-concentration doped to be a p-type. The doping concentration of the first well region of the second conductivity type 233 may be in the range of 1×10¹⁷ cm⁻³ and 1×10¹⁹ cm⁻³. The material, doping type, or doping concentration of the first well region of the second conductivity type 233 is not limited thereto, and may be variously modified.

The contact well region of the first conductivity type 237 may be positioned in the first well region of the second conductivity type 233. The contact well region of the first conductivity type 237 may be positioned within the first well region of the second conductivity type 233. The contact well region of the first conductivity type 237 may be positioned adjacent to the upper surface of the first well region of the second conductivity type 233. The upper surface of the contact well region of the first conductivity type 237 and the upper surface of the first well region of the second conductivity type 233 may have the same level in the third direction D3. For example, the upper surface of the contact well region of the first conductivity type 237 and the upper surface of the first well region of the second conductivity type 233 may be coplanar surfaces (e.g., may form a single planar surface). The first well region of the second conductivity type 233 may surround the lower surface and side surfaces of the contact well region of the first conductivity type 237.

The contact well region of the first conductivity type 237 may extend in the third direction D3 from the upper surface of the first well region of the second conductivity type 233. The contact well region of the first conductivity type 237 may be embedded within the first well region of the second conductivity type 233. At this time, the length in the third direction D3 of the contact well region of the first conductivity type 237 may be less than the length in the third direction D3 of the first well region of the second conductivity type 233.

In a plan view, the contact well region of the first conductivity type 237 may extend in the first direction D1 and the second direction D2.

For example, the contact well region of the first conductivity type 237 may extend along the periphery of the gate pad 155 under the gate pad 155. For example, a first end in the first direction D1 or the second direction D2 of the contact well region of the first conductivity type 237 may extend along the outer periphery of the first gate pad member 155_1, and a second end in the first direction D1 or the second direction D2 of the contact well region of the first conductivity type 237 may extend along the inner periphery of the second gate pad member 155_2, and a central portion in the first direction D1 or the second direction D2 of the contact well region of the first conductivity type 237 may extend along the gap between the first gate pad member 155_1 and the second gate pad member 155_2.

For example, a first end in the first direction D1 or the second direction D2 of the contact well region of the first conductivity type 237 may overlap with at least a portion of the first gate pad member 155_1 in the third direction D3, a second end in the first direction D1 or the second direction D2 of the contact well region of the first conductivity type 237 may overlap with at least a portion of the second gate pad member 155_2 in the third direction D3, and a central portion in the first direction D1 or the second direction D2 of the contact well region of the first conductivity type 237 may overlap with the gap between the first gate pad member 155_1 and the second gate pad member 155_2 in the third direction D3.

In a plan view, the contact well region of the first conductivity type 237 may have a ring shape, and for example, may have a circular ring, an elliptical ring, or a polygonal ring shape such as a triangular ring or a rectangular ring. In an inner region of the contact well region of the first conductivity type 237 having a ring shape, the first well region of the second conductivity type 233 may be positioned.

The contact well region of the first conductivity type 237 may be a doped region formed by an ion implantation process within the first well region of the second conductivity type 233. The contact well region of the first conductivity type 237 may include SiC. For example, the contact well region of the first conductivity type 237 may include 4H SiC. The contact well region of the first conductivity type 237 may be doped to be an n-type. The contact well region of the first conductivity type 237 may be highly doped to be an n-type. The doping concentration of the contact well region of the first conductivity type 237 may be in the range of 1×10¹⁸ cm⁻³ and 5×10²⁰ cm⁻³. The material, doping type, or doping concentration of the contact well region of the first conductivity type 237 is not limited thereto and may be variously modified.

A first interlayer insulating layer 160 may be positioned on the first conductivity type semiconductor layer 131. For example, the first interlayer insulating layer 160 may be positioned on the first well region of the second conductivity type 233 and the contact well region of the first conductivity type 237. The first interlayer insulating layer 160 may cover the upper surface of the first well region of the second conductivity type 233 and the contact well region of the first conductivity type 237. The first interlayer insulating layer 160 may be positioned between the first well region of the second conductivity type 233 and the gate pad 155.

The first interlayer insulating layer 160 may include an insulating material. For example, the first interlayer insulating layer 160 may include SiOP, SiN, SiON, or a combination thereof. The first interlayer insulating layer 160 may be formed as a single layer or a multilayer.

The gate pad 155 may be positioned on the first well region of the second conductivity type 233. At least a portion of the gate pad 155 may be positioned on the contact well region of the first conductivity type 237. The gate pad 155 may be positioned on the first interlayer insulating layer 160 covering the first well region of the second conductivity type 233 and the contact well region of the first conductivity type 237. The gate pad 155 may be spaced apart from the first well region of the second conductivity type 233 and the contact well region of the first conductivity type 237 in the third direction D3 by the first interlayer insulating layer 160. The gate pad 155 may be electrically connected to the contact well region of the first conductivity type 237 by the first and second gate pad contacts 155_1C, 155_2C to be described later.

The gate pad 155 may include the first gate pad member 155_1 and the second gate pad member 155_2.

The first gate pad member 155_1 and the second gate pad member 155_2 may be spaced apart from each other in the first direction D1 or the second direction D2. The first gate pad member 155_1 and the second gate pad member 155_2 may not be directly connected.

The first gate pad member 155_1 may be positioned on the contact well region of the first conductivity type 237. At least a portion of the first gate pad member 155_1 may overlap the contact well region of the first conductivity type 237 in the third direction D3. The first gate pad member 155_1 may be spaced apart from the contact well region of the first conductivity type 237 in the third direction D3 by the first interlayer insulating layer 160. The first gate pad member 155_1 may be connected to a first side in the first direction D1 or the second direction D2 of the contact well region of the first conductivity type 237 with the first interlayer insulating layer 160 interposed therebetween. The first gate pad member 155_1 may be connected to an inner periphery side of a ring shape of the contact well region of the first conductivity type 237. For example, the first gate pad member 155_1 may be electrically connected to the contact well region of the first conductivity type 237 by the first gate pad contact 155_1C.

The second gate pad member 155_2 may be positioned on the contact well region of the first conductivity type 237. At least a portion of the first gate pad member 155_1 may overlap the contact well region of the first conductivity type 237 in the third direction D3. The second gate pad member 155_2 may be spaced apart from the contact well region of the first conductivity type 237 in the third direction D3 by the first interlayer insulating layer 160. The second gate pad member 155_2 may be connected to a second side in the first direction D1 or the second direction D2 of the contact well region of the first conductivity type 237 with the first interlayer insulating layer 160 interposed therebetween. The second gate pad member 155_2 may be connected to the outer peripheral side of the ring-shaped contact well region of the first conductivity type 237. For example, the second gate pad member 155_2 may be electrically connected to the contact well region of the first conductivity type 237 by the second gate pad contact 155_2C.

The second gate pad member 155_2 may be positioned outside the first direction D1 or the second direction D2 of the first gate pad member 155_1. For example, the second gate pad member 155_2 may be extended along the periphery of the first gate pad member 155_1. The second gate pad member 155_2 may be extended to be positioned over the entire gate pad 155. For example, the second gate pad member 155_2 may surround the first gate pad member 155_1.

In a plan view, the second gate pad member 155_2 may have a frame shape surrounding the first gate pad member 155_1, and for example, may have a polygonal frame shape such as a circular frame, an elliptical frame, a triangular frame, or a rectangular frame. In a plan view, the first gate pad member 155_1 may be positioned in an inner region surrounded by the second gate pad member 155_2 having a frame shape. For example, in a plan view, the first gate pad member 155_1 may have a polygonal shape such as a circular, elliptical, triangular, or quadrilateral shape.

The first gate pad member 155_1 and the second gate pad member 155_2 are spaced apart from each other in the first direction D1 and the second direction D2, and a gap may be positioned between the first gate pad member 155_1 and the second gate pad member 155_2. The gap may have a frame shape in a plan view according to the shape of the second gate pad member 155_2, and, for example, may have a polygonal frame shape such as a circular frame, an elliptical frame, a triangular frame, or a rectangular frame. The gap may be an empty space or may be filled by an insulating material or the like.

The second gate pad member 155_2 may be positioned between the first gate pad member 155_1 and the source pad 170, the gate runner 156, and the gate bus 157. The second gate pad member 155_2 may be connected to the gate runner 156 and the gate bus 157. The first gate pad member 155_1 may be spaced apart from the source pad 170, the gate runner 156, and the gate bus 157. The first gate pad member 155_1 may not be directly connected to the source pad 170, the gate runner 156, and the gate bus 157.

The first gate pad member 155_1 is connected to a first side in the first direction D1 or the second direction D2 of the contact well region of the first conductivity type 237, and the second gate pad member 155_2 is connected to a second side in the first direction D1 or the second direction D2 of the contact well region of the first conductivity type 237, so that the first gate pad member 155_1 and the second gate pad member 155_2 may be electrically connected to each other by the contact well region of the first conductivity type 237. Accordingly, the gate pad 155 may have a resistance due to contact between the first gate pad member 155_1 and the contact well region of the first conductivity type 237, a resistance due to the contact well region of the first conductivity type 237, and a resistance due to contact between the second gate pad member 155_2 and the contact well region of the first conductivity type 237. For example, the gate pad 155 may additionally have resistance due to the contact well region of the first conductivity type 237.

For example, the semiconductor device may be used in applications such as a traction inverter, and may perform high-speed switching operation. When the gate pad 155 additionally has resistance due to the contact well region of the first conductivity type 237, it may prevent the occurrence of ringing, which is a phenomenon in which the gate voltage oscillates at high frequency due to parasitic inductance during high-speed switching operation, reduce electromagnetic interference, and prevent excessive current from flowing through the device.

When the gate pad 155 has resistance due to the contact well region of the first conductivity type 237, the resistance of the gate pad 155 may be easily adjusted by changing the resistance caused by the contact between the first gate pad member 155_1 and the second gate pad member 155_2 and the contact well region of the first conductivity type 237, or by changing the doping concentration and length of the contact well region of the first conductivity type 237.

In some examples, the first gate pad contact 155_1C may be positioned between the contact well region of the first conductivity type 237 and the first gate pad member 155_1. For example, the first gate pad member 155_1 may be electrically connected to the contact well region of the first conductivity type 237 by the first gate pad contact 155_1C.

The first gate pad contact 155_1C may penetrate through the first interlayer insulating layer 160. The first gate pad contact 155_1C may be connected to the upper surface of the contact well region of the first conductivity type 237 and the lower surface of the first gate pad member 155_1. The first gate pad contact 155_1C may be positioned on an inner periphery of the contact well region of the first conductivity type 237. The first gate pad contact 155_1C may be positioned under the outer periphery of the first gate pad member 155_1. The first gate pad contact 155_1C may connect the first gate pad member 155_1 to a first side in the first direction D1 or the second direction D2 of the contact well region of the first conductivity type 237.

For example, the first gate pad contact 155_1C may extend along the outer periphery of the lower surface of the first gate pad member 155_1. In a plan view, the first gate pad contact 155_1C may have a ring shape, and, for example, may have a circular ring, an elliptical ring, or a polygonal ring shape such as a triangular ring or a rectangular ring. In an internal region of the ring-shaped first gate pad contact 155_1C in a plan view, the first interlayer insulating layer 160 may be positioned.

The second gate pad contact 155_2C may be positioned between the contact well region of the first conductivity type 237 and the second gate pad member 155_2. For example, the second gate pad member 155_2 may be electrically connected to the contact well region of the first conductivity type 237 by the second gate pad contact 155_2C.

The second gate pad contact 155_2C may penetrate through the first interlayer insulating layer 160. The second gate pad contact 155_2C may be connected to the upper surface of the contact well region of the first conductivity type 237 and the lower surface of the second gate pad member 155_2. The second gate pad contact 155_2C may be positioned on the outer periphery of the contact well region of the first conductivity type 237. The second gate pad contact 155_2C may be positioned under an inner periphery of the second gate pad member 155_2. The second gate pad contact 155_2C may connect the second gate pad member 155_2 to the contact well region of the first conductivity type 237 at a second side in the first direction D1 or the second direction D2.

For example, the second gate pad contact 155_2C may extend along the inner periphery of the second gate pad member 155_2 at the lower surface of the second gate pad member 155_2. In a plan view, the second gate pad contact 155_2C may have a ring shape, and, for example, may have a circular ring, an elliptical ring, or a polygonal ring shape such as a triangular ring or a rectangular ring. In an inner region of the second gate pad contact 155_2C having a ring-shape in a plan view, the first interlayer insulating layer 160 and the first gate pad contact 155_1C may be positioned.

The source pad 170 may include a source electrode 172 positioned on the cell region 101 of the substrate 110 and a source pad member 171 positioned on the peripheral region 102 of the substrate 110.

The source pad member 171 may be positioned on a first side in the first direction D1 or the second direction D2 of the gate pad 155. For example, the source pad member 171 may be positioned close to a first side edge of the gate pad 155.

For example, the source pad member 171 may have a portion positioned at a first side in the first direction D1 or the second direction D2 of the gate pad 155, and a portion extending along the periphery of the gate runner 156, and a width of the portion positioned at a first side in the first direction D1 or the second direction D2 of the gate pad 155 may be greater than a width of the portion extending along the periphery of the gate runner 156.

The source pad member 171 may be spaced apart from the gate pad 155 in the first direction D1 or the second direction D2. The source pad member 171 and the gate pad 155 may not be directly connected to each other.

As the source pad member 171 and the gate pad 155 are spaced apart from each other in the first direction D1 or the second direction D2, a gap may be positioned between the source pad member 171 and the gate pad 155. The gap may be an open space, or may be filled by an insulating material or the like.

The source pad member 171 may be positioned on the first well region of the second conductivity type 233. The source pad member 171 may not be positioned on the contact well region of the first conductivity type 237. The source pad member 171 may be positioned on the first interlayer insulating layer 160 covering the first well region of the second conductivity type 233. The source pad member 171 may be spaced apart from the first well region of the second conductivity type 233 in the third direction D3 by the first interlayer insulating layer 160. The source pad member 171 may be electrically connected to the first well region of the second conductivity type 233 by a source pad contact 171C to be described later.

The source pad member 171 may be connected to the first well region of the second conductivity type 233, and the gate pad 155 may be connected to the first well region of the second conductivity type 233 through the contact well region of the first conductivity type 237, such that the gate pad 155 and the source pad member 171 of the source pad 170 may be electrically connected to each other by the first well region of the second conductivity type 233. For example, the semiconductor device may include a rectification structure connected by the contact well region of the first conductivity type 237. When an unintended negative voltage is applied to the gate pad 155, the accumulated negative charges may be extracted to the source pad member 171 through the contact well region of the first conductivity type 237 and the first well region of the second conductivity type 233, and the phenomenon in which the threshold voltage (Vₜₕ) of the device changes due to the accumulated negative charges may be prevented.

In some examples, the source pad contact 171C may be positioned between the first well region of the second conductivity type 233 and the source pad member 171. For example, the source pad member 171 may be electrically connected to the first well region of the second conductivity type 233 by the source pad contact 171C.

The source pad contact 171C may penetrate through the first interlayer insulating layer 160. The source pad contact 171C may be positioned on the first well region of the second conductivity type 233. The source pad contact 171C may be positioned below the source pad member 171. The source pad contact 171C may be connected to the upper surface of the first well region of the second conductivity type 233 and to the lower surface of the source pad member 171. The source pad contact 171C may connect the source pad member 171 to a first side in the first direction D1 or the second direction D2 of the first well region of the second conductivity type 233. The source pad contact 171C may extend along the source pad member 171 under the lower surface of the source pad member 171.

Hereinafter, with reference to FIG. 3, an example of the cell region 101 of the substrate 110 will be described.

The semiconductor device may include the first conductivity type semiconductor layer 131 positioned on the cell region 101 of the substrate 110, a second conductivity type doped well region 133 positioned in the first conductivity type semiconductor layer 131, a gate electrode 150 positioned on the first conductivity type semiconductor layer 131 and the second conductivity type doped well region 133, a gate insulating layer 151 positioned between the first conductivity type semiconductor layer 131 and the gate electrode 150, the source electrode 172 positioned on the second conductivity type doped well region 133, and the drain electrode 180 positioned below the lower surface of the substrate 110.

The second conductivity type doped well region 133 may be positioned within the first conductivity type semiconductor layer 131. The second conductivity type doped well region 133 may be positioned on an upper portion of the first conductivity type semiconductor layer 131. The second conductivity type doped well region 133 may contact a lower surface of a second conductivity type doped layer 135 to be described later. The second conductivity type doped well region 133 may surround a lower surface and side surfaces of a first conductivity type doped layer 137 to be described later.

At least a portion of the upper surface of the second conductivity type doped well region 133 may overlap with at least a portion of the gate electrode 150 and at least a portion of the gate insulating layer 151 in the third direction D3.

The second conductivity type doped well region 133 may extend from the upper surface of the first conductivity type semiconductor layer 131 toward the lower surface of the first conductivity type semiconductor layer 131. For example, the second conductivity type doped well region 133 may extend from the upper surface of the first conductivity type semiconductor layer 131 in the third direction D3 to a certain depth. The second conductivity type doped well region 133 may be formed in at least a portion of the first conductivity type semiconductor layer 131 through an ion implantation method.

The second conductivity type doped well region 133 may include SiC. For example, the second conductivity type doped well region 133 may include 4H SiC. The second conductivity type doped well region 133 may be doped with a p-type. The second conductivity type doped well region 133 may be low-concentration doped with a p-type. The doping concentration of the second conductivity type doped well region 133 may be in the range of 1×10¹⁷ cm⁻³ and 1×10¹⁹ cm⁻³. The material, doping type, or doping concentration of the second conductivity type doped well region 133 is not limited thereto and may be variously modified.

In some examples, the semiconductor device may further include a second conductivity type doped layer 135 and a first conductivity type doped layer 137 positioned on an upper portion of the first conductivity type semiconductor layer 131.

The second conductivity type doped layer 135 may be positioned within the second conductivity type doped well region 133. The second conductivity type doped layer 135 may be positioned on an upper portion of the first conductivity type semiconductor layer 131, and may have an upper surface contacting a lower surface of a first silicide layer 190 connected to the source electrode 172.

At least a portion of an upper surface of the second conductivity type doped layer 135 may be in contact with a lower surface of the first silicide layer 190, but is not limited thereto. For example, at least a portion of the upper surface of the second conductivity type doped layer 135 may contact the lower surface of the source electrode 172. At this time, the second conductivity type doped layer 135 may have a width wider than a width of the source electrode 172.

The second conductivity type doped layer 135 may extend in the third direction D3 from the upper surface of the first conductivity type semiconductor layer 131. In this case, the thickness in the third direction D3 of the second conductivity type doped layer 135 may be less than the thickness in the third direction D3 of the second conductivity type doped well region 133. In addition, the second conductivity type doped layer 135 may have a width narrower than the second conductivity type doped well region 133. For example, the second conductivity type doped layer 135 may be embedded within the second conductivity type doped well region 133. The second conductivity type doped layer 135 may be formed in at least a portion of the second conductivity type doped well region 133 by an ion implantation method.

The second conductivity type doped layer 135 may include SiC. For example, the second conductivity type doped layer 135 may include 4H SiC. The second conductivity type doped layer 135 may be doped to have a p-type. The second conductivity type doped layer 135 may form an ohmic contact with the source electrode 172. To this end, the second conductivity type doped layer 135 may be doped with a high concentration in a p-type. In some examples, a doping concentration of the second conductivity type doped layer 135 may be higher than a doping concentration of the second conductivity type doped well region 133. The doping concentration of the second conductivity type doped layer 135 may be in the range of 1×10¹⁸ cm⁻³ and 5×10²⁰ cm⁻³. The material, doping type, or doping concentration of the second conductivity type doped layer 135 is not limited thereto and may be variously changed.

The first conductivity type doped layer 137 may be positioned within the second conductivity type doped well region 133. The first conductivity type doped layer 137 is positioned on an upper portion of the first conductivity type semiconductor layer 131, and may surround both side surfaces of the second conductivity type doped layer 135. The upper surface of the first conductivity type doped layer 137 may overlap with at least a portion of the gate electrode 150, which will be described later, and at least a portion of the gate insulating layer 151 in the third direction D3. In addition, the upper surface of the first conductivity type doped layer 137 may overlap with at least a portion of the source electrode 172 in the third direction D3, but is not limited thereto. The upper surface of the first conductivity type doped layer 137 may contact the gate insulating layer 151 to be described later.

The first conductivity type doped layer 137 may extend in the third direction D3 from the upper surface of the first conductivity type semiconductor layer 131. The first conductivity type doped layer 137 may be embedded within the second conductivity type doped well region 133. At this time, the thickness in the third direction D3 of the first conductivity type doped layer 137 may be less than the thickness in the third direction D3 of the second conductivity type doped well region 133.

The first conductivity type doped layer 137 may be a doped region formed within the first conductivity type semiconductor layer 131 by using an ion implantation process. The first conductivity type doped layer 137 may include SiC. For example, the first conductivity type doped layer 137 may include 4H SiC. The first conductivity type doped layer 137 may be doped as an n-type. The first conductivity type doped layer 137 may be highly doped as an n-type. The doping concentration of the first conductivity type doped layer 137 may be 1×10¹⁸ cm⁻³ or more and 5×10²⁰ cm⁻³ or less. The material, doping type, or doping concentration of the first conductivity type doped layer 137 is not limited thereto and may be variously modified.

The gate electrode 150 may be positioned on the first conductivity type semiconductor layer 131. The gate electrode 150 may be spaced apart from the first conductivity type semiconductor layer 131. For example, the gate electrode 150 may be spaced apart from the first conductivity type semiconductor layer 131 in a vertical direction (for example, the third direction D3) by the gate insulating layer 151. In some examples, the semiconductor device may have a planar type gate structure. For example, in the semiconductor device, the gate electrode 150 may have a flat plate shape having a flat upper surface and a flat lower surface, and the lower surface of the gate electrode 150 may be positioned at a higher level than an uppermost surface of the first conductivity type semiconductor layer 131. However, this is not limited thereto, and the semiconductor device according to some examples may have a trench-type gate structure. For example, the semiconductor device may have a trench of a predetermined depth formed in the first conductivity type semiconductor layer 131, and the gate electrode 150 may be positioned spaced apart from the first conductivity type semiconductor layer 131 in the third direction D3 inside the trench. In addition, the gate electrode 150 may be positioned spaced apart from the first conductivity type semiconductor layer 131 in the first direction D1 and/or the second direction D2. The gate electrode 150 may overlap the second conductivity type doped well region 133 and the first conductivity type doped layer 137 in the third direction D3.

The gate electrode 150 may include a conductive material. For example, the gate electrode 150 may include polysilicon doped with an impurity. As another example, the gate electrode 150 may include a metal, a metal alloy, a conductive metal nitride, a metal silicide, a doped semiconductor material, a conductive metal oxide, a conductive metal oxynitride, or a combination thereof. The gate electrode 150 may be formed of a single layer or a multilayer.

The gate insulating layer 151 may be positioned between the first conductivity type semiconductor layer 131 and the gate electrode 150. For example, the gate insulating layer 151 may be positioned below the gate electrode 150 in the third direction D3, and may cover the lower surface of the gate electrode 150. The gate electrode 150 may be insulated from the first conductivity type semiconductor layer 131 by the gate insulating layer 151. The thickness of the gate insulating layer 151 may be substantially uniform.

The gate insulating layer 151 may overlap the second conductivity type doped well region 133 and the first conductivity type doped layer 137 in the third direction D3. A lower surface of the gate insulating layer 151 may contact the second conductivity type doped well region 133 and the first conductivity type doped layer 137, but is not limited thereto.

The gate insulating layer 151 may include an insulating material. For example, the gate insulating layer 151 may include SiO₂. However, this is not limited thereto, and the material of the gate insulating layer 151 may be variously changed. As another example, the gate insulating layer 151 may include SiN, SiON, SiC, SiCN, or a combination thereof. The gate insulating layer 151 may be formed of a single layer or a multilayer.

The second interlayer insulating layer 140 may be positioned on the first conductivity type semiconductor layer 131. For example, the second interlayer insulating layer 140 may be positioned on the gate electrode 150. For example, the second interlayer insulating layer 140 may cover the upper surface and side surfaces of the gate electrode 150. The second interlayer insulating layer 140 may cover the side surface of the gate insulating layer 151. The second interlayer insulating layer 140 may be positioned on the first conductivity type doped layer 137. The second interlayer insulating layer 140 may have a lower surface contacting at least a portion of the upper surface of the first conductivity type doped layer 137. The gate electrode 150 may be insulated from the source electrode 172 by the second interlayer insulating layer 140.

The second interlayer insulating layer 140 may include an insulating material. For example, the second interlayer insulating layer 140 may include the same insulating material as the gate insulating layer 151. For example, the second interlayer insulating layer 140 may include SiO₂. However, this is not limited thereto, and the second interlayer insulating layer 140 may include various types of insulating material for insulating the gate electrode 150 from the source electrode 172. For example, the second interlayer insulating layer 140 may include SiOP, SiN, SiON, or a combination thereof. The second interlayer insulating layer 140 may be formed as a single layer or a multilayer. When the second interlayer insulating layer 140 is formed of the same material as the gate insulating layer 151, the boundary between the second interlayer insulating layer 140 and the gate insulating layer 151 at a portion where the second interlayer insulating layer 140 is in contact with the gate insulating layer 151 may not be clearly distinguished.

The source electrode 172 may be positioned on the second conductivity type doped well region 133. The second conductivity type doped layer 135 and the first conductivity type doped layer 137 may be positioned between the source electrode 172 and the second conductivity type doped well region 133. The source electrode 172 may be electrically connected to the second conductivity type doped well region 133 by the second conductivity type doped layer 135. The source electrode 172 may be positioned on opposite sides of the gate electrode 150. However, it is not limited thereto, and the source electrode 172 may be positioned only at one side of the gate electrode 150. The second interlayer insulating layer 140 may be positioned between the source electrode 172 and the gate electrode 150. Current or voltage may be provided to the semiconductor device through the source electrode 172. The source electrode 172 may be spaced apart from the gate electrode 150 by the second interlayer insulating layer 140. The source electrode 172 may be in contact with the side surface of the second interlayer insulating layer 140.

For example, it is described that a portion of the source electrode 172 positioned between gate electrodes 150 adjacent in the first direction D1 overlaps the second conductivity type doped layer 135 and the first conductivity type doped layer 137 in the third direction D3, but this is not limited thereto. For example, the portion of the source electrode 172 positioned between the gate electrodes 150 adjacent to each other in the first direction D1 may be non-overlapping with the first conductivity type doped layer 137 in the third direction D3. At this time, the upper surface of the first conductivity type doped layer 137 may be covered by the gate insulating layer 151.

The source electrode 172 may include a conductive material. For example, the source electrode 172 may include a metal, a metal alloy, a conductive metal nitride, a metal silicide, a doped semiconductor material, a conductive metal oxide, or a conductive metal oxynitride. For example, the source electrode 172 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The source electrode 172 may be formed of a single layer or a multilayer.

The semiconductor device may further include the first silicide layer 190 positioned between the source electrode 172 and the second conductivity type doped layer 135, and between the source electrode 172 and the first conductivity type doped layer 137.

The first silicide layer 190 may be conformally positioned along the interfaces between the source electrode 172 and the second conductivity type doped layer 135, and between the source electrode 172 and the first conductivity type doped layer 137. The lower surface of the first silicide layer 190 may contact the second conductivity type doped layer 135 and the first conductivity type doped layer 137. The upper surface of the first silicide layer 190 may contact the source electrode 172. The first silicide layer 190 may include a metal silicide material. For example, the first silicide layer 190 may include tungsten-silicide (WSi), titanium-silicide (TiSi), cobalt-silicide (CoSi), nickel-silicide (NiSi), or a combination thereof.

In a manufacturing process of the semiconductor device, a silicidation process may be performed on the upper surfaces of the second conductivity type doped layer 135 and the first conductivity type doped layer 137 to form the first silicide layer 190. However, this is not limited thereto, and after forming the source electrode 172, in order to reduce the contact resistance between the second conductivity type doped layer 135 and the source electrode 172, and between the first conductivity type doped layer 137 and the source electrode 172, an annealing process may subsequently be performed. Accordingly, the first silicide layer 190 may be formed along the interface between the source electrode 172 and the second conductivity type doped layer 135, and between the source electrode 172 and the first conductivity type doped layer 137.

The drain electrode 180 may be positioned below the second surface (e.g., the lower surface) of the substrate 110. The upper surface of the drain electrode 180 may contact the lower surface of the substrate 110. The drain electrode 180 may be ohmically contacted with the substrate 110. A region in the substrate 110 in contact with the drain electrode 180 may be doped at a relatively high concentration compared to other regions. However, it is not limited thereto, and another predetermined layer may be further positioned between the drain electrode 180 and the substrate 110. For example, a silicide layer may be positioned between the drain electrode 180 and the substrate 110. The silicide layer may include a metal silicide material. An electrical connection between the drain electrode 180 and the substrate 110 may be smoothly achieved by the metal silicide layer.

The drain electrode 180 may include a conductive material. For example, the drain electrode 180 may include a metal, a metal alloy, a conductive metal nitride, a metal silicide, a doped semiconductor material, a conductive metal oxide, or a conductive metal oxynitride, and the like. The drain electrode 180 may be formed of the same material as the source electrode 172, or may be formed of a different material.

For example, the drain electrode 180 may include titanium (Ti), titanium nitride (TiN), titanium silicon nitride (TiSiN), titanium aluminum nitride (TiAIN), titanium carbide (TiC), titanium aluminum (TiAl), titanium aluminum carbonitride (TiAIC-N), titanium aluminum carbide (TiAIC), tantalum (Ta), tantalum carbide (TaC), tantalum nitride (TaN), tantalum carbonitride (TaCN), tantalum silicon nitride (TaSiN), tantalum titanium nitride (TaTiN), tantalum aluminum nitride (TaAIN), tungsten (W), tungsten nitride (WN), tungsten carbide (WC), aluminum (Al), copper (Cu), cobalt (Co), nickel (Ni), nickel-vanadium (Ni-V), nickel-platinum (Ni-Pt), vanadium (V), zinc (Zn), niobium (Nb), niobium nitride (NbN), niobium carbide (NbC), molybdenum (Mo), molybdenum nitride (MoN), molybdenum carbide (MoC), ruthenium (Ru), platinum (Pt), rhodium (Rh), palladium (Pd), iridium (Ir), osmium (Os), silver (Ag), gold (Au), or a combination thereof, but is not limited thereto. The drain electrode 180 may be formed of a single layer or a multilayer.

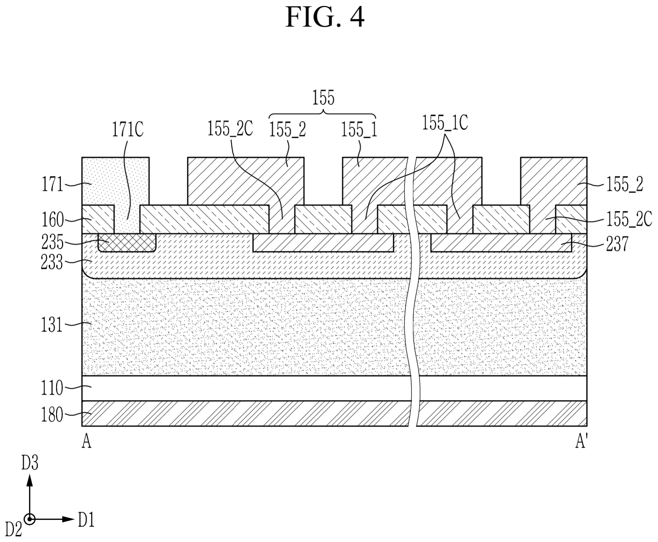

Hereinafter, a semiconductor device according to several examples will be described with reference to FIGS. 4 to 8.

FIG. 4 is a cross-sectional view showing a semiconductor device according to an example, corresponding to FIG. 2. The example shown in FIG. 4 is substantially the same as the example shown in FIG. 2 with respect to identical portions, and therefore, detailed description thereof may be omitted and differences will be mainly described. In addition, the same reference numerals are used for the same components as in the preceding example.

Referring to FIG. 4, the semiconductor device may further include a contact well region of the second conductivity type 235 positioned in the first well region of the second conductivity type 233.

The contact well region of the second conductivity type 235 may be positioned under the source pad member 171 in the third direction D3. The contact well region of the second conductivity type 235 may be positioned between the first well region of the second conductivity type 233 and the source pad member 171. The source pad member 171 of the source pad 170 may be electrically connected to the contact well region of the second conductivity type 235. The contact well region of the second conductivity type 235 may lower contact resistance between the source pad member 171 and the first well region of the second conductivity type 233.

The contact well region of the second conductivity type 235 may be positioned in the first well region of the second conductivity type 233. The contact well region of the second conductivity type 235 may be positioned within the first well region of the second conductivity type 233. The contact well region of the second conductivity type 235 may be positioned on an upper portion of the first well region of the second conductivity type 233. The upper surface of the contact well region of the second conductivity type 235 and the upper surface of the first well region of the second conductivity type 233 may have the same level in the third direction D3. For example, the upper surface of the contact well region of the second conductivity type 235 and the upper surface of the first well region of the second conductivity type 233 may be a coplanar surface. The first well region of the second conductivity type 233 may surround the lower surface and the side surface of the contact well region of the second conductivity type 235.

The contact well region of the second conductivity type 235 may extend in the third direction D3 from the upper surface of the first well region of the second conductivity type 233. The contact well region of the second conductivity type 235 may be embedded within the first well region of the second conductivity type 233. At this time, the thickness in the third direction D3 of the contact well region of the second conductivity type 235 may be less than the thickness in the third direction D3 of the first well region of the second conductivity type 233.

In a plan view, the contact well region of the second conductivity type 235 may extend in the first direction D1 or the second direction D2. For example, the contact well region of the second conductivity type 235 may extend along the source pad member 171 under the source pad member 171.

The contact well region of the second conductivity type 235 may be formed by ion implantation in at least a portion of the first well region of the second conductivity type 233. The contact well region of the second conductivity type 235 may include SiC. For example, the contact well region of the second conductivity type 235 may include 4H SiC. The contact well region of the second conductivity type 235 may be doped with a p-type. The contact well region of the second conductivity type 235 may form an ohmic contact with the source pad member 171. To this end, the contact well region of the second conductivity type 235 may be doped with a high concentration as a p-type. In some examples, the doping concentration of the contact well region of the second conductivity type 235 may be higher than the doping concentration of the first well region of the second conductivity type 233. The doping concentration of the contact well region of the second conductivity type 235 may be 1×10¹⁸ cm⁻³ or more and 5×10²⁰ cm⁻³ or less. The material, doping type, or doping concentration of the contact well region of the second conductivity type 235 is not limited thereto, and may be variously changed.

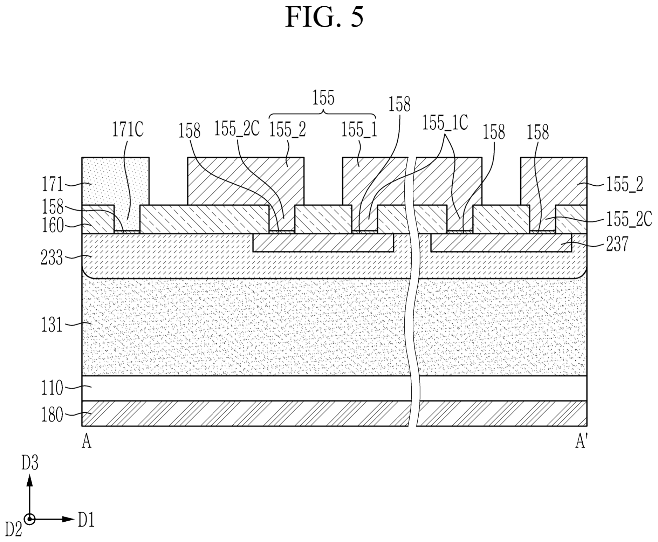

FIG. 5 is a cross-sectional view showing a semiconductor device according to an example, and corresponds to FIG. 2. The example shown in FIG. 5 is substantially the same as the example shown in FIG. 2 with respect to identical portions, and therefore, detailed description thereof may be omitted and differences will be mainly described. In addition, the same reference numerals are used for the same components as in the preceding example.

Referring to FIG. 5, a second silicide layer 158 may be positioned between the first gate pad contact 155_1C and the second gate pad contact 155_2C and the contact well region of the first conductivity type 237. The second silicide layer 158 may lower the contact resistance between the first gate pad member 155_1 and the second gate pad member 155_2 and the contact well region of the first conductivity type 237. The resistance of the gate pad 155 may be adjusted depending on the presence or absence of the second silicide layer 158.

In addition, the second silicide layer 158 may be positioned between the source pad contact 171C and the first well region of the second conductivity type 233. The second silicide layer 158 may lower the contact resistance between the source pad member 171 and the first well region of the second conductivity type 233.

For example, the second silicide layer 158 may include titanium silicide, tantalum silicide, tungsten silicide, nickel silicide, cobalt silicide, molybdenum silicide, or a combination thereof.

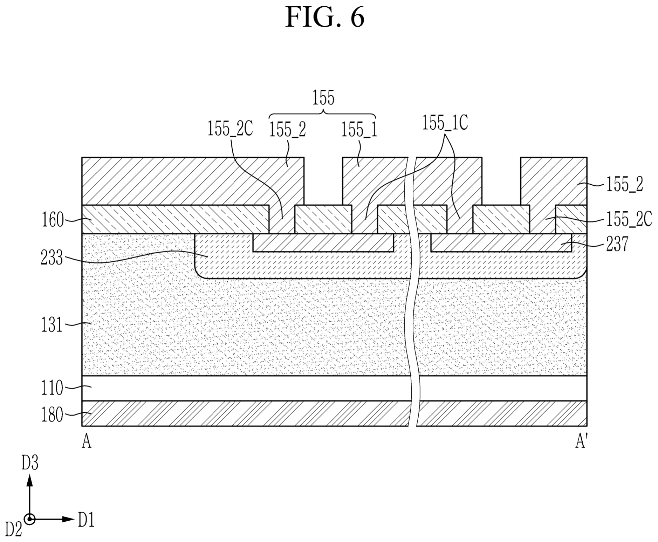

FIG. 6 is a cross-sectional view showing a semiconductor device according to an example, and corresponds to FIG. 2. The example shown in FIG. 6 is substantially the same as the example shown in FIG. 2 with respect to identical portions, and therefore, detailed description thereof may be omitted and differences will be mainly described. In addition, the same reference numerals are used for the same components as in the preceding example.

Referring to FIG. 2, a case is illustrated in which the source pad 170 may include the source pad member 171 positioned on the peripheral region 102 of the substrate 110.

Referring to FIG. 6, the source pad 170 may include the source electrode 172 positioned on the cell region 101 of the substrate 110, but may not include the source pad member 171 positioned on the peripheral region 102 of the substrate 110.

At the outermost periphery of the semiconductor device in a plan view, the gate pad 155 and the gate runner 156 may be positioned. The source pad 170 may be surrounded by the gate runner 156. For example, at the outermost periphery of the semiconductor device, the source pad member 171 surrounding the gate runner 156 may not be positioned.

For example, the gate runner 156 may extend to be positioned over the entire peripheral region 102 of the substrate 110, and may have a completely closed frame shape. For example, one end of the gate runner 156 and the other end thereof may be connected to each other. The source pad 170 may be positioned only in an inner region of the gate runner 156.

In this case, the peripheral region 102 of the substrate 110 may be defined as a region in which the gate pad 155, gate runner 156, and gate bus 157 are positioned.

In this example, the source pad member 171 may not be positioned on the first well region of the second conductivity type 233. The second gate pad member 155_2 may extend to cover one end in the first direction D1 of the first well region of the second conductivity type 233.

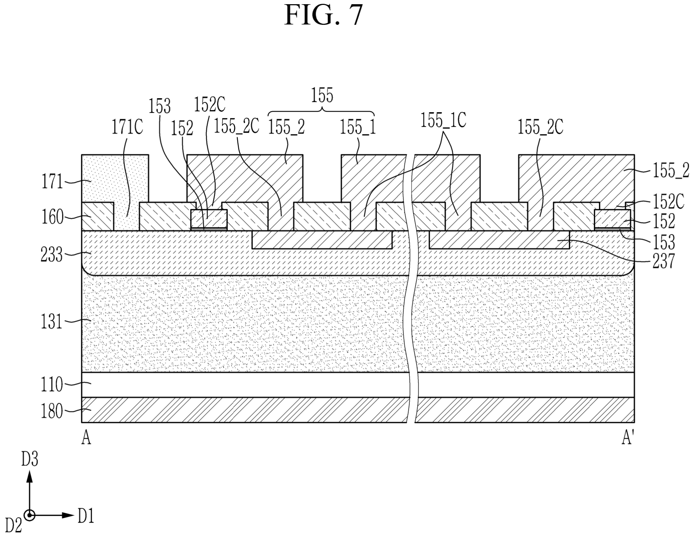

FIG. 7 is a cross-sectional view showing a semiconductor device according to an example, and corresponds to FIG. 2. The example shown in FIG. 7 is substantially the same as the example shown in FIG. 2 with respect to identical portions, and therefore, detailed description thereof may be omitted and differences will be mainly described. In addition, the same reference numerals are used for the same components as in the preceding example.

Referring to FIG. 7, a first gate electrode member 152 may be positioned on the peripheral region 102 of the substrate 110. The first gate electrode member 152 may be connected to the gate pad 155. The first gate electrode member 152 may be extended and connected to the gate electrode 150 of the cell region 101 of the substrate 110. For example, the gate electrode 150 of the cell region 101 of the substrate 110 may be connected to the gate pad 155 through the first gate electrode member 152.

For example, the first gate electrode member 152 may be positioned under the second gate pad member 155_2. For example, the first gate electrode member 152 may be positioned below the outer periphery of the second gate pad member 155_2. The first gate electrode member 152 may overlap the second gate pad member 155_2 in the third direction D3. The first gate electrode member 152 may be electrically connected to the second gate pad member 155_2. The first gate electrode member 152 may be electrically connected to the gate pad 155 by a gate contact 152C, which will be described later.

In FIG. 7, the first gate electrode member 152 is positioned below the second gate pad member 155_2, and the first gate electrode member 152 is not positioned below the first gate pad member 155_1, but is not limited thereto. The first gate electrode member 152 may be positioned below the first gate pad member 155_1. The first gate electrode member 152 may overlap the first gate pad member 155_1 in the third direction D3. The first gate electrode member 152 may be directly connected to the first gate pad member 155_1.

The first gate electrode member 152 may be elongated in the first direction D1 or the second direction D2. For example, the first gate electrode member 152 may have a bar shape elongated along the first direction D1 or the second direction D2 in a plan view. For example, when the first gate electrode member 152 extends in the second direction D2, a plurality of first gate electrode members 152 may be spaced apart and arranged in the first direction D1. Alternatively, when the first gate electrode member 152 extends in the first direction D1, a plurality of first gate electrode members 152 may be spaced apart and arranged in the second direction D2. The first interlayer insulating layer 160, the first gate pad contacts 155_1C, or the second gate pad contact 155_2C and the like may be positioned between the plurality of first gate electrode members 152.

The first gate electrode member 152 may be positioned on the first well region of the second conductivity type 233. The first gate electrode member 152 may be positioned between the first well region of the second conductivity type 233 and the second gate pad member 155_2. The first gate electrode member 152 may be spaced apart from the first well region of the second conductivity type 233. For example, the first gate electrode member 152 may be spaced apart from the first well region of the second conductivity type 233 in a vertical direction (for example, the third direction D3) by the gate electrode member insulating layer 153.

Meanwhile, the first gate electrode member 152 may not be positioned on the contact well region of the first conductivity type 237. The first gate electrode member 152 may not be connected to the contact well region of the first conductivity type 237. The first gate electrode member 152 may not overlap the contact well region of the first conductivity type 237 in the third direction D3.

The first gate electrode member 152 may be positioned within the first interlayer insulating layer 160. The first gate electrode member 152 may be covered by the first interlayer insulating layer 160. For example, the first interlayer insulating layer 160 may cover a portion of the side surface and upper surface of the first gate electrode member 152. A portion of an upper surface of the first gate electrode member 152 that is not covered by the first interlayer insulating layer 160 may be connected to a gate contact 152C, which will be described later. The level in the third direction D3 of the upper surface of the first interlayer insulating layer 160 may be higher than the level in the third direction D3 of the upper surface of the first gate electrode member 152.

The first gate electrode member 152 may include a conductive material. For example, the first gate electrode member 152 may include polysilicon doped with an impurity. As another example, the first gate electrode member 152 may include a metal, a metal alloy, a conductive metal nitride, a metal silicide, a doped semiconductor material, a conductive metal oxide, a conductive metal oxynitride, or a combination thereof. The first gate electrode member 152 may be formed of a single layer or a multilayer.

The gate electrode member insulating layer 153 may be positioned between the first well region of the second conductivity type 233 and the first gate electrode member 152. That is, the gate electrode member insulating layer 153 may be positioned below the first gate electrode member 152 in the third direction D3, and may cover the lower surface of the first gate electrode member 152. The first gate electrode member 152 may be insulated from the first well region of the second conductivity type 233 by the gate electrode member insulating layer 153. The thickness of the gate electrode member insulating layer 153 may be substantially uniform.

The gate electrode member insulating layer 153 may overlap the first well region of the second conductivity type 233 in the third direction D3. The lower surface of the gate electrode member insulating layer 153 may contact the first well region of the second conductivity type 233, but is not limited thereto.

The gate electrode member insulating layer 153 may be elongated along the first gate electrode member 152 in the first direction D1 or the second direction D2. For example, the gate electrode member insulating layer 153 may have a rod shape elongated along the first direction D1 or the second direction D2 in a plan view.

The gate electrode member insulating layer 153 may include an insulating material. For example, the gate electrode member insulating layer 153 may include SiO₂. However, this is not limited thereto, and the material of the gate electrode member insulating layer 153 may be variously changed. For example, the gate electrode member insulating layer 153 may include SiN, SiON, SiC, SiCN, or a combination thereof. The gate electrode member insulating layer 153 may be formed as a single layer or a multilayer.

The gate contact 152C may be positioned between the first gate electrode member 152 and the second gate pad member 155_2. For example, the first gate electrode member 152 may be electrically connected to the second gate pad member 155_2 by the gate contact 152C.

The gate contact 152C may penetrate the first interlayer insulating layer 160. The gate contact 152C may be positioned on the upper surface of the first gate electrode member 152. The gate contact 152C may be positioned below the outer periphery of the second gate pad member 155_2. The gate contact 152C may be connected to the upper surface of the first gate electrode member 152 and the lower surface of the second gate pad member 155_2.

The gate contact 152C may be elongated along the first direction D1 or the second direction D2 along the first gate electrode member 152. For example, the gate contact 152C may have a rod shape elongated along the first direction D1 or the second direction D2 in a plan view.

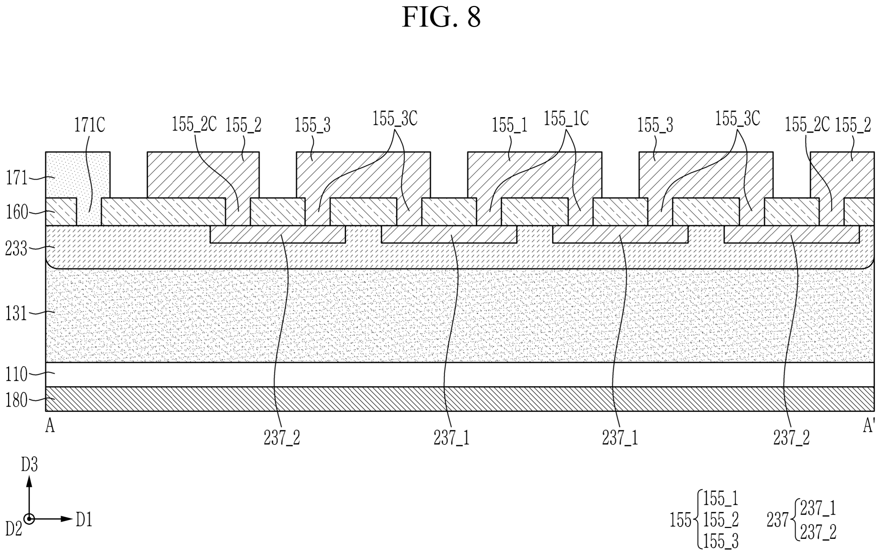

FIG. 8 is a cross-sectional view showing a semiconductor device according to an example, and corresponds to FIG. 2. The example illustrated in FIG. 8 is substantially the same as the example shown in FIG. 2 with respect to identical portions, and therefore, detailed description thereof may be omitted and differences will be mainly described. In addition, the same reference numerals are used for the same components as in the preceding example.

Referring to FIG. 8, the gate pad 155 may further include a third gate pad member 155_3 positioned between the first gate pad member 155_1 and the second gate pad member 155_2.

The third gate pad member 155_3, the first gate pad member 155_1, and the second gate pad member 155_2 may be spaced apart in the first direction D1 and the second direction D2. The third gate pad member 155_3 may not be directly connected to the first gate pad member 155_1 and the second gate pad member 155_2.

For example, the third gate pad member 155_3 may extend along the periphery of the first gate pad member 155_1. For example, the third gate pad member 155_3 may surround the first gate pad member 155_1. The second gate pad member 155_2 extends along the periphery of the third gate pad member 155_3, and may surround the third gate pad member 155_3.

In a plan view, the third gate pad member 155_3 may have a frame shape surrounding the first gate pad member 155_1, and, for example, may have a circular frame, an elliptical frame, or a polygonal frame shape such as a triangular frame or a rectangular frame.

The contact well region of the first conductivity type 237 may include the first contact well region of the first conductivity type 237_1 positioned below between the first gate pad member 155_1 and the third gate pad member 155_3, and the second contact well region of the first conductivity type 237_2 positioned below between the second gate pad member 155_2 and the third gate pad member 155_3.

In a plan view, the first contact well region of the first conductivity type 237_1 may extend in the first direction D1 and the second direction D2, and the second contact well region of the first conductivity type 237_2 may extend in the first direction D1 and the second direction D2.

For example, the first contact well region of the first conductivity type 237_1 may extend along the periphery of the first gate pad member 155_1 and the third gate pad member 155_3 under the first gate pad member 155_1 and the third gate pad member 155_3. For example, one end in the first direction D1 or the second direction D2 of the first contact well region of the first conductivity type 237_1 may extend along the outer periphery of the first gate pad member 155_1, and the other end in the first direction D1 or the second direction D2 of the first contact well region of the first conductivity type 237_1 may extend along the inner periphery of the third gate pad member 155_3.

In addition, the second contact well region of the first conductivity type 237_2 may extend along the periphery of the second gate pad member 155_2 and the third gate pad member 155_3 under the second gate pad member 155_2 and the third gate pad member 155_3. For example, one end in the first direction D1 or the second direction D2 of the second contact well region of the first conductivity type 237_2 may extend along the outer periphery of the third gate pad member 155_3, and the other end in the first direction D1 or the second direction D2 of the second contact well region of the first conductivity type 237_2 may extend along the inner periphery of the second gate pad member 155_2.

In a plan view, the first contact well region of the first conductivity type 237_1 and the second contact well region of the first conductivity type 237_2 may each have a ring shape, and, for example, may have a circular ring, an elliptical ring, or a polygonal ring shape such as a triangular ring or a rectangular ring. In the internal region of the first contact well region of the first conductivity type 237_1 having a ring-shape in a plan view, the first well region of the second conductivity type 233 may be positioned, and in the internal region of the second contact well region of the first conductivity type 237 having a ring-shape, the first contact well region of the first conductivity type 237_1 and the first well region of the second conductivity type 233 may be positioned.

The first gate pad member 155_1 may be connected to an inner periphery side of the first contact well region of the first conductivity type 237_1 having a ring-shape. The third gate pad member 155_3 may be connected to the outer periphery of the first contact well region of the first conductivity type 237_1 having a ring-shape. In addition, the third gate pad member 155_3 may be connected to an inner peripheral side of the second contact well region of the first conductivity type 237_2 having a ring-shape. The second gate pad member 155_2 may be connected to the outer periphery of the second contact well region of the first conductivity type 237_2 having a ring-shape.

The first gate pad member 155_1 is connected to a first side of the first contact well region of the first conductivity type 237_1, the third gate pad member 155_3 is connected to a second side of the first contact well region of the first conductivity type 237_1, the third gate pad member 155_3 is connected to a first side of the second contact well region of the first conductivity type 237_2, and the second gate pad member 155_2 is connected to a second side of the second contact well region of the first conductivity type 237_2, such that the first gate pad member 155_1, the second gate pad member 155_2, and the third gate pad member 155_3 may be electrically connected to each other by the first contact well region of the first conductivity type 237_1 and the second contact well region of the first conductivity type 237_2. Accordingly, the gate pad 155 may additionally have resistance due to the first contact well region of the first conductivity type 237_1 and the second contact well region of the first conductivity type 237_2.

For example, the semiconductor device may be used in applications such as a traction inverter, and may perform a high-speed switching operation. When the gate pad 155 additionally has resistance due to the first contact well region of the first conductivity type 237_1 and the second contact well region of the first conductivity type 237_2, it may prevent the occurrence of ringing, which is a phenomenon in which the gate voltage oscillates at a high frequency due to parasitic inductance even during high-speed switching operation, may reduce electromagnetic interference, and may prevent excessive current from flowing through the device.

In addition, when the gate pad 155 has resistance due to the first contact well region of the first conductivity type 237_1 and the second contact well region of the first conductivity type 237_2, the resistance of the gate pad 155 may be easily adjusted by changing the contact resistance between the first gate pad member 155_1, the second gate pad member 155_2, and the third gate pad member 155_3 and the contact well region of the first conductivity type 237, or by adjusting the doping concentration and length of the first contact well region of the first conductivity type 237_1 and the second contact well region of the first conductivity type 237_2.

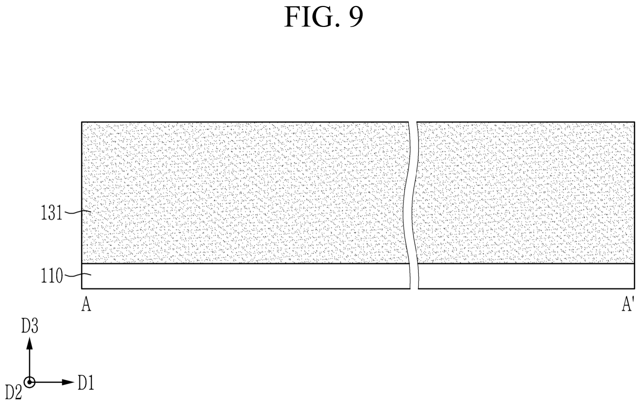

Hereinafter, a method of manufacturing a semiconductor device according to several examples will be described with reference to FIGS. 9 to 17.

FIGS. 9 to 17 are process cross-sectional views sequentially showing a method of manufacturing a semiconductor device according to an example.

Referring to FIG. 9, a first conductivity type semiconductor layer 131 may be formed on the substrate 110.

For example, the first conductivity type semiconductor layer 131 may be formed on the first surface, that is, the upper surface of the substrate 110, by using an epitaxial growth method. The first conductivity type semiconductor layer 131 may be formed right on the substrate 110, or after forming another layer on the substrate 110, the first conductivity type semiconductor layer 131 may be formed thereon.

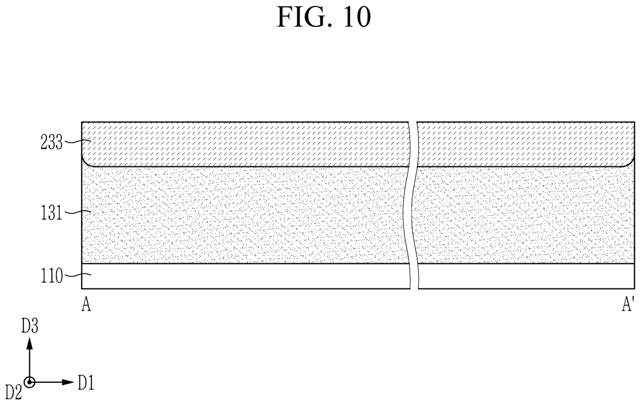

Referring to FIG. 10, a first well region of the second conductivity type 233 may be formed on the first conductivity type semiconductor layer 131 positioned on the peripheral region 102 of the substrate 110.

For example, the first well region of the second conductivity type 233 may be formed by an ion implantation process (IIP). First, a region in which the first well region of the second conductivity type 233 may be formed on the first conductivity type semiconductor layer 131 may be defined by using a photolithography process. Thereafter, second conductivity type impurity ions may be implanted into the corresponding region. The first well region of the second conductivity type 233 may have a predetermined depth. At this time, the depth of the first well region of the second conductivity type 233 may be determined by the number of ions injected and/or the velocity at which the ions are accelerated. The substrate 110 during ion implantation may not be heated, or may be heated to 200 °C to 800 °C.

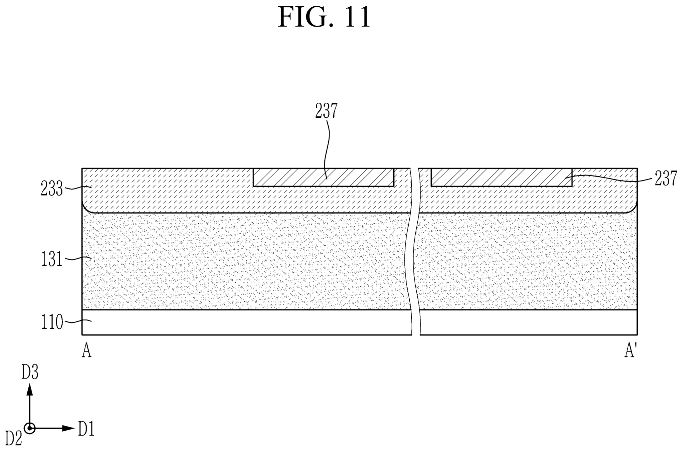

Referring to FIG. 11, a contact well region of the first conductivity type 237 may be formed in the first well region of the second conductivity type 233.

For example, the contact well region of the first conductivity type 237 may be formed within the first well region of the second conductivity type 233 through an ion implantation process. At least a portion of the first well region of the second conductivity type 233 may have the contact well region of the first conductivity type 237 formed therein. For example, the contact well region of the first conductivity type 237 may be formed below a position where the gate pad 155 is to be formed later.

First, by using a photolithography process, a region in which the contact well region of the first conductivity type 237 is to be formed may be defined on the first well region of the second conductivity type 233. Thereafter, first conductivity type impurity ions may be implanted into the corresponding region. The contact well region of the first conductivity type 237 may have a predetermined depth. At this time, the depth of the contact well region of the first conductivity type 237 may be determined by the number of ions injected and/or the speed at which the ions are accelerated. When ions are implanted at a high concentration, the substrate 110 may be heated to 150°C or higher.

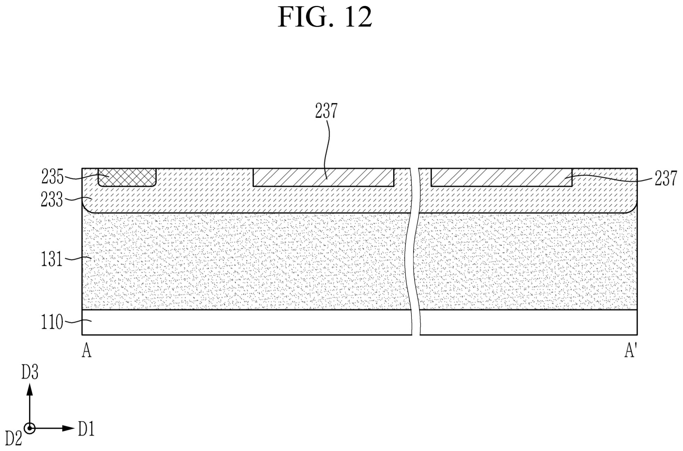

Referring to FIG. 12, in some examples, the contact well region of the second conductivity type 235 may further be formed in the first well region of the second conductivity type 233.

For example, the contact well region of the second conductivity type 235 may be formed within the first well region of the second conductivity type 233 through an ion implantation process. At least a portion of the first well region of the second conductivity type 233 may have a contact well region of the second conductivity type 235 formed therein. For example, the contact well region of the second conductivity type 235 may be formed below the position where the source pad member 171 is to be subsequently formed.

First, by using a photolithography process, a region in which the contact well region of the second conductivity type 235 is to be formed on the first well region of the second conductivity type 233 may be defined. Subsequently, second conductivity type impurity ions may be implanted into the corresponding region. The contact well region of the second conductivity type 235 may have a predetermined depth. In this case, the depth of the contact well region of the second conductivity type 235 may be determined by the number of ions to be implanted and/or the velocity at which the ions are accelerated.

In some examples, after ion implantation, annealing may be performed in an inert gas atmosphere such as argon (Ar) gas or nitrogen gas, or in a vacuum, at a temperature of 1500 °C to 2200 °C for 30 minutes to 60 minutes, so that the ion-implanted impurity may be electrically activated. For example, annealing may be performed in a state where the substrate 110 and layers formed on the substrate 110 are covered with a carbon layer. Damage to the SiC surface, which may be generated by moisture or oxygen remaining in the device during annealing, may be prevented by the carbon layer.

Next, a thermal oxide layer may be formed by sacrificially oxidizing the surface of the first conductivity type semiconductor layer 131 in which the first well region of the second conductivity type 233, the contact well region of the first conductivity type 237, and the like are formed, and by removing the thermal oxide layer with hydrofluoric acid, the surface altered layer of the ion-implanted first conductivity type semiconductor layer 131 may be removed and a clean surface may be exposed.

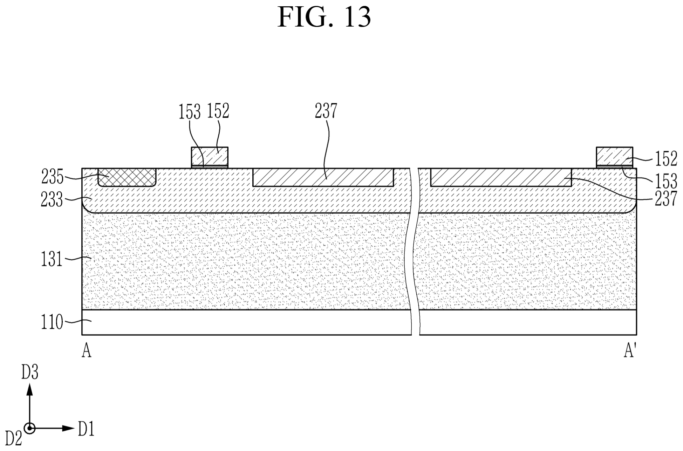

Referring to FIG. 13, in some examples, a gate electrode member insulating layer 153 and a first gate electrode member 152 may be sequentially formed on the first well region of the second conductivity type 233.

First, a field insulation layer may be formed on the first conductivity type semiconductor layer 131. For example, the field insulation layer may cover the first conductivity type semiconductor layer 131, and may expose a portion of the first well region of the second conductivity type 233, the contact well region of the first conductivity type 237, and the contact well region of the second conductivity type 235.

The gate electrode member insulating layer 153 may be formed on the exposed first well region of the second conductivity type 233. The gate electrode member insulating layer 153 may be formed using a thermal oxidation method or a deposition method. The gate electrode member insulating layer 153 may have a thickness smaller than the field insulation layer.

Next, a first gate electrode member 152 may be formed on the gate electrode member insulating layer 153.

For example, the first gate electrode member 152 may be formed by using a chemical vapor deposition (CVD) method, a photolithography method, and the like. In some examples, the first gate electrode member 152 may be formed also on a portion of the field insulation layer.

After forming the gate electrode member insulating layer 153 and the first gate electrode member 152, the gate electrode member insulating layer 153 and the first gate electrode member 152 may be patterned so that the gate electrode member insulating layer 153 and the first gate electrode member 152 are positioned only on the first well region of the second conductivity type 233 and at the position where a second gate pad member 155_2 is to be formed, and a portion of the gate electrode member insulating layer 153 and the first gate electrode member 152 may be removed. Patterning of the gate electrode member insulating layer 153 and the first gate electrode member 152 may be performed using, for example, a photolithography method or a dry etching method.

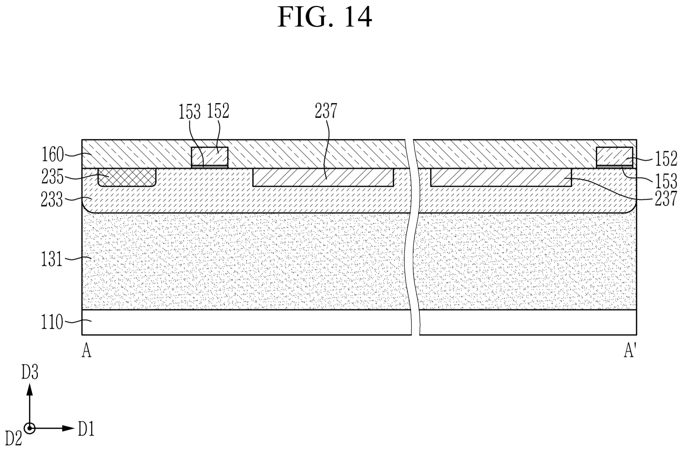

Referring to FIG. 14, a first interlayer insulating layer 160 may be formed on the first well region of the second conductivity type 233.

The first interlayer insulating layer 160 may be formed to cover the first gate electrode member 152, the first conductivity type semiconductor layer 131, the first well region of the second conductivity type 233, the contact well region of the first conductivity type 237, and the contact well region of the second conductivity type 235.

The first interlayer insulating layer 160 may be formed by a deposition method such as a chemical vapor deposition (CVD) method.

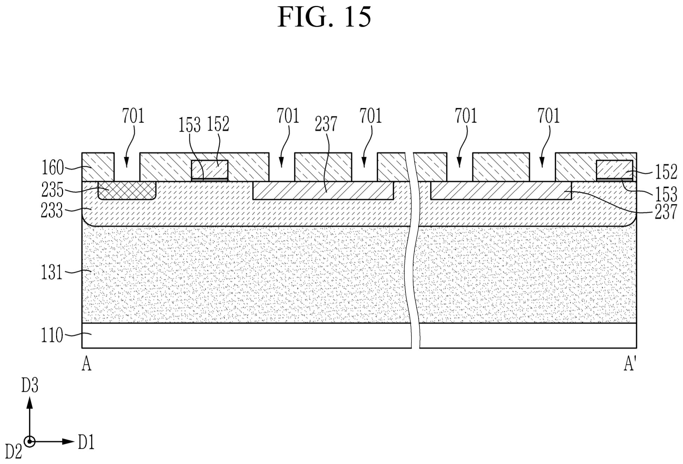

Referring to FIG. 15, the first interlayer insulating layer 160 may be patterned such that a portion of the first interlayer insulating layer 160 is removed.

For example, a portion of the first interlayer insulating layer 160 may be removed to expose a portion of the upper surface of the contact well region of the first conductivity type 237 and a portion of the upper surface of the contact well region of the second conductivity type 235. A portion of the first interlayer insulating layer 160 may be removed, so that a first trench 701 may be formed. The region in which a portion of the first interlayer insulating layer 160 is removed may be a region where the first and second gate pad contacts 155_1C, 155_2C and the source pad contact 171C are to be formed.

Removal of the first interlayer insulating layer 160 may utilize, for example, a photolithography method or a dry etching method.

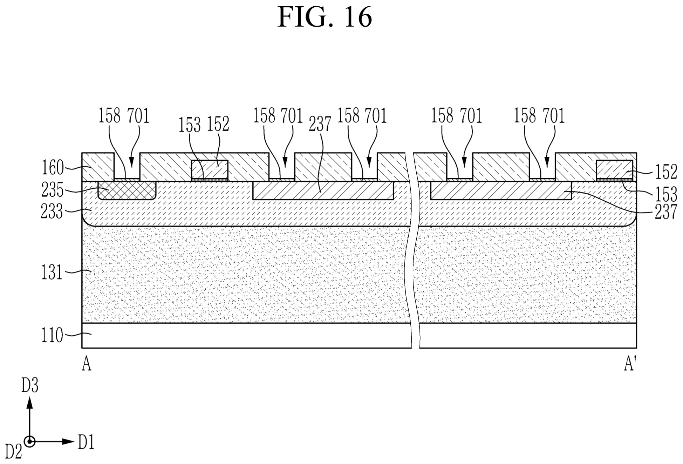

Referring to FIG. 16, in some examples, a second silicide layer 158 may be formed.

The second silicide layer 158 may be formed in a region where a portion of the first interlayer insulating layer 160 is removed by patterning the first interlayer insulating layer 160. The second silicide layer 158 may be formed on the upper surface of the contact well region of the first conductivity type 237 and on the upper surface of the contact well region of the second conductivity type 235, where a portion of the first interlayer insulating layer 160 is removed and exposed.

For example, a metal layer may be formed on the upper surface of the contact well region of the first conductivity type 237 and on the upper surface of the contact well region of the second conductivity type 235 by a sputtering method or the like, and heat treatment may be performed at 600°C to 1100°C to react the metal with SiC and form a silicide.

In some examples, the metal layer remaining on the first interlayer insulating layer 160 other than the silicide formed by the reaction may be removed by wet etching using a mixture of sulfuric acid, nitric acid, hydrochloric acid, or these acids with hydrogen peroxide, or the like.

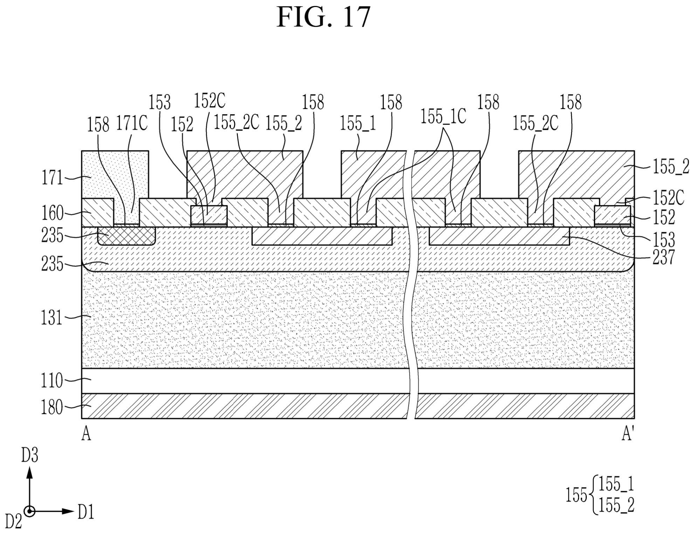

Referring to FIG. 17, a gate pad 155 and a source pad member 171 may be formed on the first interlayer insulating layer 160.

First, the first interlayer insulating layer 160 may be patterned to expose a portion of the upper surface of the first gate electrode member 152. A region in which a portion of the first interlayer insulating layer 160 is removed may be an area in which the gate contact 152C is to be formed later.

The removal of the first interlayer insulating layer 160 may, for example, use a photolithography method or a dry etching method.

Next, the gate pad 155 and the source pad member 171 may be formed on the first interlayer insulating layer 160.

First, a conductive material may be deposited over the entire surface of the first interlayer insulating layer 160 and then subjected to heat treatment. The conductive material may be formed by a sputtering method or a deposition method, or the like.

At this time, the first interlayer insulating layer 160 is patterned so that within the first trench 701, from which a portion of the first interlayer insulating layer 160 is removed, the first and second gate pad contacts 155_1C, 155_2C, the gate contact 152C, and the source pad contact 171C may be formed. The first and second gate pad contacts 155_1C, 155_2C, gate contact 152C, and source pad contact 171C may be formed on the second silicide layer 158.

The first gate pad contact 155_1C may be formed to connect the first gate pad member 155_1 to the contact well region of the first conductivity type 237. The second gate pad contact 155_2C may be formed to connect the second gate pad member 155_2 to the contact well region of the first conductivity type 237. The gate contact 152C may be formed to connect the second gate pad member 155_2 to the first gate electrode member 152. The source pad contact 171C may be formed to connect the source pad member 171 to the first well region of the second conductivity type 233.

Subsequently, the conductive material may be patterned to form the first gate pad member 155_1 and the second gate pad member 155_2 of the gate pad 155, and the source pad member 171. Patterning of the conductive material may utilize a photolithography method or the like.

The first gate pad member 155_1 and the second gate pad member 155_2 are spaced apart from each other, and the first gate pad member 155_1 may be formed to be connected to a first side of the contact well region of the first conductivity type 237, and the second gate pad member 155_2 may be formed to be connected to a second side of the contact well region of the first conductivity type 237.

The source pad member 171 may be spaced apart from the gate pad 155, may be connected to the first well region of the second conductivity type 233, and may be formed to be connected to the gate pad 155 through the first well region of the second conductivity type 233.

As such, the gate pad 155 and the source pad member 171 may be formed simultaneously in the same process. In addition, the gate pad 155, the first and second gate pad contacts 155_1C, 155_2C, and the gate contact 152C may be formed simultaneously in the same process. The source pad member 171 and the source pad contact 171C may be formed simultaneously in the same process. However, it is not limited thereto, and the gate pad 155, the source pad member 171, the first and second gate pad contacts 155_1C, 155_2C, the gate contact 152C, and the source pad contact 171C may be formed separately in another process.

In some examples, the drain electrode 180 may be formed on the second surface of the substrate 110.

For example, the process of forming the drain electrode 180 may include applying a conductive material over the entire second surface of the substrate 110 and forming by heat treatment. The application of the conductive material may be formed by a sputtering method or a deposition method.

A method of manufacturing a semiconductor device according to another aspect may include providing a substrate having a cell region and a peripheral region positioned on a first side of the cell region, forming a first conductivity type semiconductor layer on the substrate, forming a first well region of a second conductivity type in the first conductivity type semiconductor layer, forming a contact well region of the first conductivity type in the first well region of the second conductivity type, and forming a gate pad on the first well region of the second conductivity type, wherein forming the gate pad includes forming a first gate pad member connected to a first side of the contact well region of the first conductivity type and forming a second gate pad member connected to a second side of the contact well region of the first conductivity type and spaced apart from the first gate pad member.

The method of manufacturing the semiconductor device may include further forming a first interlayer insulating layer between the first well region of the second conductivity type and the gate pad.

Forming the first gate member may include patterning the first interlayer insulating layer to further form a first gate pad contact connecting the first gate pad member to a first side of the contact well region of the first conductivity type through the first interlayer insulating layer.

Forming the second gate member may include patterning the first interlayer insulating layer to further form a second gate pad contact connecting the second gate pad member to the second side of the contact well region of the first conductivity type through the first interlayer insulating layer.

Forming the first and second gate members may include patterning the first interlayer insulating layer, further forming a silicide layer on the contact well region of the first conductivity type, and forming first and second gate pad contacts on the silicide layer.

The method of manufacturing the semiconductor device may include further forming a gate electrode member insulating layer on the first well region of the second conductivity type, further forming a first gate electrode member on the gate electrode member insulating layer, and forming the first interlayer insulating layer to cover the first gate electrode member.

Forming the first gate electrode member may include patterning the first interlayer insulating layer to further form a gate contact connecting the second gate pad member to the first gate electrode member through the first interlayer insulating layer.

The method of manufacturing the semiconductor device may include further forming a source pad member on the first well region of the second conductivity type.

The source pad member may be formed to be spaced apart from the gate pad, connected to the first well region of the second conductivity type, and electrically connected to the gate pad through the first well region.

Forming the source pad member may include, after further forming a contact well region of the second conductivity type in the first well region of the second conductivity type, forming the source pad member on the contact well region of the second conductivity type.

Forming the source pad member may include patterning the first interlayer insulating layer to further form a source pad contact connecting the source pad member to the first well region of the second conductivity type through the first interlayer insulating layer.

Forming the source pad member may include, after patterning the first interlayer insulating layer, further forming a silicide layer on the first well region of the second conductivity type, and forming the source pad on the silicide layer.

Although example embodiments of the present disclosure have been described in detail above, the scope of rights of the present disclosure is not limited thereto, and various modifications and improvements by those skilled in the art utilizing the basic concept of the present disclosure as defined in the following claims also belong to the scope of the present disclosure.

## Claims

1. A semiconductor device comprising:
a substrate (110) having a cell region (101) and a peripheral region (102) positioned at a side of the cell region (101);
a semiconductor layer (131) of a first conductivity type positioned on the peripheral region (102) of the substrate (110);
a first well region of a second conductivity type (233) positioned in the semiconductor layer (131) of the first conductivity type;
a contact well region of the first conductivity type (237) positioned in the first well region of the second conductivity type (233); and
a gate pad (155) positioned on the first well region of the second conductivity type (233),
wherein the gate pad (155) includes a first gate pad member (155_1) connected to a first side of the contact well region of the first conductivity type (237) and a second gate pad member (155_2) spaced apart from the first gate pad member (155_1) and connected to a second side of the contact well region of the first conductivity type (237).

2. The semiconductor device of claim 1, wherein the electrical resistance of the gate pad (155) is determined through electrical resistance resulting from contact of the first gate pad member (155_1) and the contact well region of the first conductivity type (237), electrical resistance of the contact well region of the first conductivity type (237), and electrical resistance resulting from contact of the second gate pad member (155_2) and the contact well region of the first conductivity type (237).

3. The semiconductor device of claim 1 or claim 2, wherein in a plan view, the second gate pad member (155_2) has a frame shape surrounding the first gate pad member (155_1).

4. The semiconductor device of any preceding claim, wherein the semiconductor device further includes a gate runner (156) extending from the gate pad (155) along the peripheral region (102) of the substrate (110) to surround the cell region (101) in a plan view and a gate bus (157) extending from the gate pad (155) and crossing a portion of the cell region (101) of the substrate (110) in the plan view,
wherein the second gate pad member (155_2) is connected to the gate bus (157) and the gate runner (156), and
wherein the first gate pad member (155_1) is spaced apart from the gate bus (157) and the gate runner (156).

5. The semiconductor device of any preceding claim, wherein:
the semiconductor device further includes a first interlayer insulating layer (160) positioned between the first well region of the second conductivity type (233) and the gate pad (155),
the first gate pad member (155_1) is connected to the first side of the contact well region of the first conductivity type (237) through the first interlayer insulating layer (160), and
the second gate pad member (155_2) is connected to the second side of the contact well region of the first conductivity type (237) through the first interlayer insulating layer (160), and
wherein the semiconductor device further includes:
a first gate pad contact (155_1C) positioned between the contact well region of the first conductivity type (237) and the first gate pad member (155_1), penetrating the first interlayer insulating layer (160), and connecting the first gate pad member (155_1) to the first side of the contact well region of the first conductivity type (237), and
a second gate pad contact (155_2C) positioned between the contact well region of the first conductivity type (237) and the second gate pad member (155_2), penetrating the first interlayer insulating layer (160), and connecting the second gate pad member (155_2) to the second side of the contact well region of the first conductivity type (237).

6. The semiconductor device of claim 5, wherein the semiconductor device further includes a silicide layer (158) positioned between the first gate pad contact (151_1C) and the first side of the contact well region of the first conductivity type (237), and between the second gate pad contact (155_2C) and the second side of the contact well region of the first conductivity type (237).

7. The semiconductor device of any preceding claim, wherein the semiconductor device further includes:
a first gate electrode member (152) positioned over the first well region of the second conductivity type (233) and connected to the gate pad (155), and
a gate electrode member insulating layer (153) positioned between the first well region of the second conductivity type (233) and the first gate electrode member (152), and
wherein:
the first gate electrode member (152) is connected to the second gate pad member (155_2), and
the first gate electrode member (152) is not connected to the contact well region of the first conductivity type (237).

8. The semiconductor device of any preceding claim, wherein the gate pad (155) further includes a third gate pad member, with the second gate pad member (155_2) positioned between the first gate pad member (155_1) and the third gate pad member, and the second gate pad member (155_2) spaced apart from the first gate pad member and the third gate pad member.

9. The semiconductor device of claim 8, wherein:
the contact well region of the first conductivity type (237) is a first contact well region of the first conductivity type (237_1) of a plurality of contact well regions of the first conductivity type (237), the semiconductor device further comprising a second contact well region of the first conductivity type (237_2),
the first contact well region of the first conductivity type (237_1) is positioned below and vertically overlaps a first space between the first gate pad member (155_1) and the second gate pad member (155_2) and the second contact well region of the first conductivity type (237_2) is positioned below and vertically overlaps a second space between the second gate pad member (155_2) and the third gate pad member, and
wherein:
the first gate pad member (155_1) is connected to a first side of the first contact well region of the first conductivity type (237_1),
the second gate pad member (155_2) is connected to a second side of the first contact well region of the first conductivity type (237_1),
the second gate pad member (155_2) is connected to a first side of the second contact well region of the first conductivity type (237_2), and
the third gate pad member is connected to a second side of the second contact well region of the first conductivity type (237_2).

10. The semiconductor device of claim 1, wherein the semiconductor layer (131) of the first conductivity type extends into and is positioned on the cell region (101) of the substrate (110) and the semiconductor device further comprises:
a second conductivity type doped well region (133) positioned in the semiconductor layer (131) of the first conductivity type;
a gate electrode (150) positioned on the semiconductor layer (131) of the first conductivity type and connected to the gate pad (155);
a gate insulating layer (151) positioned between the semiconductor layer (131) of the first conductivity type and the gate electrode (150),
a source electrode (172) positioned on the second conductivity type doped well region (133), and
a drain electrode (180) positioned below a lower surface of the substrate (110).

11. The semiconductor device of claim 1, wherein the semiconductor device further includes a source pad (170) connected to the first well region of the second conductivity type (233) and spaced apart from the gate pad (155),
wherein the gate pad (155) and the source pad (170) are connected to each other by the first well region of the second conductivity type (233).

12. The semiconductor device of claim 11,
wherein the semiconductor device further includes a contact well region of the second conductivity type (235) positioned in the first well region of the second conductivity type (233), and
wherein the source pad (170) is connected to the contact well region of the second conductivity type (235).

13. The semiconductor device of claim 11 or claim 12,
wherein the source pad (170) includes a source electrode (172) positioned on the cell region (101) of the substrate (110), and a source pad member (171) positioned on the peripheral region (102) of the substrate (110) and positioned at a side of the gate pad (155), and
wherein the source pad member (171) is connected to the first well region of the second conductivity type (233) and connected to the gate pad (155) through the first well region of the second conductivity type (233).

14. The semiconductor device of claim 13,
wherein the semiconductor device further includes a gate runner (156) extending from the gate pad (155) along the peripheral region (102) of the substrate (110) in a plan view and a gate bus (157) extending from the gate pad (155) crossing the cell region (101) of the substrate (110) in the plan view,
wherein the gate pad (155), the gate runner (156), and the gate bus (157) are spaced apart from the source pad (170), and
wherein, in the plan view, the source pad member (171) has a frame shape surrounding the gate runner (156).

15. The semiconductor device of claim 13 or claim 14,
wherein the semiconductor device further includes a first interlayer insulating layer (160) positioned between the first well region of the second conductivity type (233) and the gate pad (155) and between the first well region of the second conductivity type (233) and the source pad (170), and
wherein the source pad member (171) is connected to the first well region of the second conductivity type (233) with the first interlayer insulating layer (160) interposed therebetween, and
wherein the semiconductor device further includes a source pad contact (171C) positioned between the first well region of the second conductivity type (233) and the source pad member (171), penetrating through the first interlayer insulating layer (160), and connecting the source pad member (171) to the first well region of the second conductivity type (233).
